(19)

**Europäisches Patentamt**

**European Patent Office**

**Office européen des brevets**

(11) **EP 4 773 033 A1**

(12) **EUROPEAN PATENT APPLICATION**

(43) Date of publication:
**08.07.2026   Bulletin 2026/28**

(21) Application number: **25305002.5**

(22) Date of filing: **02.01.2025**

(51) International Patent Classification (IPC):
***G06F 30/17*** *(2020.01)*

(52) Cooperative Patent Classification (CPC):
**G06F 30/17; G06F 30/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Dassault Systèmes**
**78140 Vélizy-Villacoublay (FR)**

(72) Inventors:
- **BELTRAND, Nicolas**
  **Vélizy-Villacoublay (FR)**
- **BOUFARGUINE, Mourad**
  **Vélizy-Villacoublay (FR)**

(74) Representative: **Bandpay & Greuter**
**11, rue Christophe Colomb**
**75008 Paris (FR)**

(54) **UPDATING 3D MODELED OBJECTS BASED ON GRAPHICAL INTERACTIONS**

(57)     The disclosure notably relates to a computer-implemented method of designing a 3D modeled object representing a mechanical product. The 3D modeled object has a feature tree and an original value of a set of semantic parameters. The method comprises by a user graphically interacting with the 3D representation, and in particular, graphically selecting a semantic point of an outer surface of the 3D modeled object and graphically selecting one or more target 3D positions of the semantic point. The method further comprises, automatically, iteratively modifying the value of the set of semantic parameters. Thereby the method obtains an updated value of the set of semantic parameters. The method further comprises, automatically by the CAD system, updating the 3D representation of the 3D modeled object based on the updated value of the set of semantic parameters. This provides an improved solution for updating 3D modeled objects based on graphical interactions.

EP 4 773 033 A1

**Description**

**TECHNICAL FIELD**

The disclosure relates to the field of computer programs and systems, and more specifically to a method, system and program for updating 3D modeled objects based on graphical interactions.

**BACKGROUND**

A number of solutions, hardware and software, are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for analyzing and simulating the physical behavior of a future product. CAM is an acronym for Computer-Aided Manufacturing, e.g. it relates to software solutions for defining product manufacturing processes and resources. In such computer-aided design solutions, the graphical user interface plays an important role as regards the efficiency of the technique. These techniques may be embedded within Product Lifecycle Management (PLM) solutions. PLM refers to an engineering strategy that helps companies to share product data, apply common processes, and leverage corporate knowledge for the development of products from conception to the end of their life, across the concept of extended enterprise. The PLM solutions provided by Dassault Systèmes (under the trademarks CATIA, SIMULIA, DELMIA and ENOVIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the solutions deliver common models linking products, processes, resources to enable dynamic, knowledge-based product creation and decision support that drives optimized product definition, manufacturing preparation, production and service.

Designing 3D modeled objects is a long process involving combining many different operators. The operators may consist in, for example, creating, modifying, and/or combining one or more geometric objects. These operators are usually stored in a feature tree and may be influenced by parameters. The user, after introducing the operators, may want to edit the value of some of the parameters to modify the 3D modeled object. However, in some cases, the user may not know exactly which parameters to modify to obtain a desired output, in other cases the feature tree may be so large that the user may have to spend a long time navigating within it.

Within this context, there is still a need for an improved solution for updating 3D modeled objects based on graphical interactions.

**SUMMARY**

It is therefore provided a computer-implemented method of designing a 3D modeled object representing a mechanical product. The 3D modeled object has a feature tree and an original value of a set of semantic parameters. Each semantic parameter is associated to a respective node of the feature tree.

The method comprises, by a CAD system, displaying a 3D representation of the 3D modeled object.

The method also comprises a user graphically interacting with the 3D representation. The graphical interaction comprises graphically selecting a semantic point of an outer surface of the 3D modeled object, the semantic point having an original 3D position. The graphical interaction further comprises graphically selecting one or more target 3D positions of the semantic point.

The method further comprises, automatically by the CAD system, determining a leaf node of the feature tree representing a portion of the outer surface to which the semantic point belongs.

The method further comprises, automatically by the CAD system, determining a list of subsets of the set of semantic parameters. The list starts with a subset consisting of any semantic parameter associated to the determined leaf node. Each further subset in the list consists of the union between the previous subset in the list and any semantic parameter associated to any respective node of the feature tree among one or more respective nodes of the feature tree. Each respective node among the one or more respective nodes has a graph distance from the determined leaf node higher than the respective node of each semantic parameter of the previous subset. The list ends with the set of semantic parameters.

The method further comprises, automatically by the CAD system, iteratively modifying the value of the set of semantic parameters, following the list. An updated value of the set of semantic parameters is thereby obtained. The iterative modifying comprises at each iteration a reduction of an error between the one or more target 3D positions and a current 3D position of the semantic point. The iterative modifying is restricted at each iteration to the semantic parameters of the current subset of the list.

The method further comprises, automatically by the CAD system, updating the 3D representation of the 3D modeled object based on the updated value of the set of semantic parameters.

The method may comprise one or more of the following:

- the iterative modifying comprises initializing to zero a cumulated variation vector that represents a cumulated variation of the semantic parameters of the set of semantic parameters, and the reduction of the error at each iteration comprises computing an optimal variation vector ($x_f$) that represents an optimal variation of the semantic parameters of the current subset of the list that minimizes a distance between a product of a variation matrix with a candidate variation vector and a corresponding value of the error, the variation matrix representing a variation of a 3D position of the semantic point relative to a variation of the semantic parameters of the current subset of the list, the iterative modifying comprising at each iteration updating the cumulated variation vector by adding the value of each coordinate of the optimal variation vector to the corresponding coordinate of the cumulated variation vector;
- the variation matrix represents a variation of the original 3D position of the semantic point relative to a variation of the semantic parameters of the current subset of the list;
- the optimal variation vector minimizes said distance under a constraint that penalizes any variation of the value of the semantic parameters of the previous subset in the list relative to the any semantic parameter of the current subset of the list;
- the constraint consists in an equality to 0 of the product of a constraint matrix with the candidate variation vector, the constraint matrix being a square matrix having a non-zero value on its diagonal for each coordinate corresponding to a semantic parameter of the previous subset in the list, and a zero value elsewhere, the non-zero value being optionally positive and/or constant, for example equal to 1;
- the optimal variation vector is equal to the sum between a variation vector of minimal norm that minimizes said distance and a product of a kernel matrix of the variation matrix with an adjustment vector of minimal norm such that the constraint is met;
- the variation vector of minimal norm is equal to the product of a pseudo-inverse ($J'^+$) of the variation matrix with the value of the error, the variation vector of minimal norm being optionally determined using a Moore-Penrose inverse method, and/or the adjustment vector of minimal norm is equal to the opposite of the product of a first sub-product with a second sub-product, the first sub-product being a pseudo-inverse of the product of the constraint matrix with the kernel matrix, the second sub-product being the product of the constraint matrix with the variation vector of minimal norm, the adjustment vector of minimal norm being optionally determined using a Moore-Penrose inverse method;
- at least one semantic parameter has a bounded definition domain, the iterative modifying comprising at each iteration, after the updating, applying an out-of-boundary management process configured for clamping each value of a respective semantic parameter out of its definition domain to a nearest boundary;
- the error in the reduction at each iteration is equal to a distance between a value of a measurement of the one or more target 3D positions and a value of a measurement of the original 3D position as modified by the cumulated variation vector;
- the displaying of the 3D representation of the 3D modeled object is performed on a screen of the CAD system based on a viewpoint, the graphically selecting of the semantic point comprises selecting a first 2D position of the screen such that a line from the viewpoint and intersecting the first 2D position also intersects the 3D representation, and the graphically selecting of the one or more target 3D positions comprises selecting a second 2D position of the screen, the one or more target 3D positions consisting of all 3D positions of the line from the viewpoint and intersecting the second 2D position;
- the graphically selecting of the semantic point and the graphically selecting of the one or more target 3D positions are performed both at once via a drag-and-drop manipulation, and/or the updating of the 3D representation is performed real time upon the graphically selecting of the semantic point and/or the graphically selecting of the one or more target 3D positions; and/or
- the mechanical product is an assembly of mechanical parts, each leaf node representing at least a portion of an outer surface of one and only one respective mechanical part.

It is further provided a computer program comprising instructions for performing the method.

It is further provided a computer readable storage medium having recorded thereon the computer program.

It is further provided a system comprising a processor coupled to a memory, the memory having recorded thereon the computer program. The system may further comprise a graphical user interface coupled to the processor.

**BRIEF DESCRIPTION OF THE DRAWINGS**

Non-limiting examples will now be described in reference to the accompanying drawings, where:

- FIG. 1 shows a flowchart of an example of the method;

- FIG.s 2A-9 illustrate example implementations of the method; and
- FIG. 10 shows an example of the system.

**DETAILED DESCRIPTION**

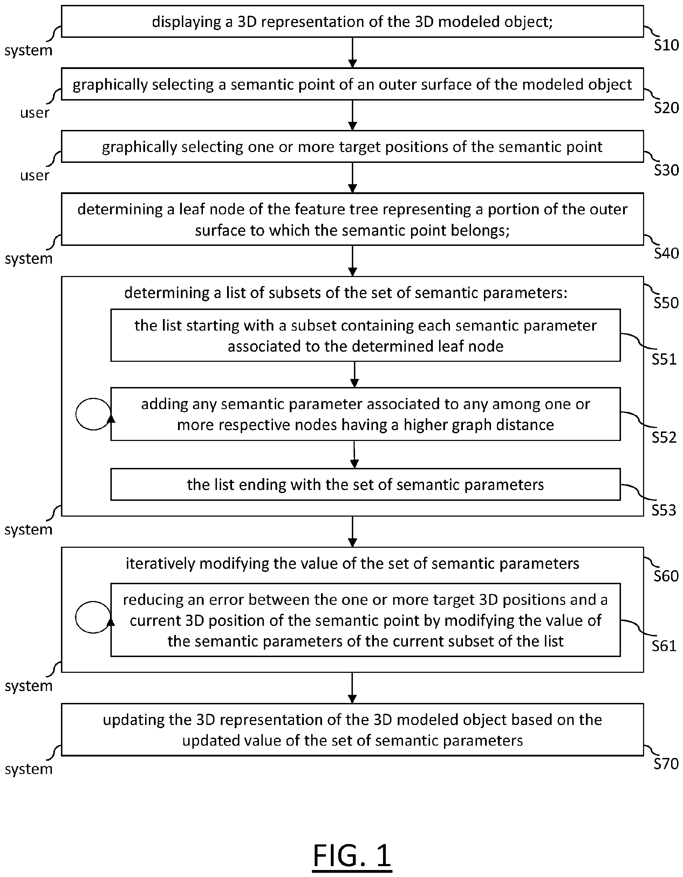

With reference to the flowchart of FIG. 1, it is proposed a computer-implemented method for designing a 3D modeled object representing a mechanical product, with a CAD system. The 3D modeled object has a feature tree and an original value of a set of semantic parameters. Each semantic parameter is associated to a respective node of the feature tree. As known, the CAD system may be configured for displaying a tree representation of the 3D modeled object, and/or for a user to select any semantic parameter and edit its value at will, by manually entering a specific value for the semantic parameter using any appropriate means (such as, as non-limiting examples, entering a numeric value in prompt of a dialog box, or selecting a discrete value in a drop-down menu). Each semantic parameter is thus manually user-editable. The method, however, offers another means for the user to edit semantic parameters.

In specific, the method comprises, by the CAD system, displaying S10 (e.g., on a screen) a 3D representation of the 3D modeled object.

The method further comprises a user graphically interacting with the 3D representation. The graphical interaction of the user comprises graphically selecting S20 a semantic point of an outer surface of the 3D modeled object (e.g., with a mouse-click or a touch gesture on a sensitive screen or sensitive pad), the semantic point having an original 3D position. The graphical interaction of the user further comprises (e.g., chronologically after S20) graphically selecting S30 one or more target 3D positions of the semantic point (e.g., with a -e.g., other- mouse-click or touch gesture, or alternatively with a mouse-release or respectively a touch-release forming a drag-and-drop interaction together with the selection S20, e.g., with a move of the mouse cursor or touch object between S20 and S30).

The method further comprises performing a certain process S40-S70, that results in an update of the 3D representation of the 3D modeled object at S70. The process S40-S70 is performed fully automatically by the CAD system, with no intervention of the user.

The automatic process comprises determining S40 a leaf node of the feature tree, said leaf node representing a portion of the outer surface, the semantic point belonging to said portion.

The automatic process further comprises determining S50 a list of subsets of the set of semantic parameters. The list starts S51 with a subset consisting of any semantic parameter associated to the determined leaf node. In other words, the first element of the list consists of all semantic parameter(s) associated to the leaf node determined at S40. Each further subset in the list consists of the union between the previous subset in the list and any semantic parameter associated to any respective node of the feature tree among one or more respective nodes of the feature tree. Each respective node among said one or more respective nodes has a graph distance from the determined leaf node higher than the respective node of each semantic parameter of the previous subset. In other words, each (but the first) element of the list consists of all semantic parameter(s) of the previous element of the list, plus additional semantic parameter(s) defined based on a graph distance from the leaf node determined at S40. The list ends S53 with the set of semantic parameters. In other words, the last element of the list consists of the whole set of semantic parameters of the feature tree.

Thus, one may consider a node-wise list of subsets of the set of all nodes of the feature tree. The node-wise list may start with the leaf node determined at S40 (i.e., first element of the node-wise list), and each further subset in the node-wise list may consist of the union between the previous subset in the node-wise list and one or more additional nodes, each additional node having a graph distance from the determined leaf node higher than each node of the previous subset, the node-wise list ending with the set of all nodes of the feature tree. The list of subsets of the set of semantic parameters determined at S50 may have the same size as such a node-wise list, and each element of the list determined at S50 of a given index may consist of the union over the node or all nodes in the element of node-wise list of the same given index, of the semantic parameter or all semantic parameters (if any) associated to any given node.

The automatic process further comprises iteratively modifying S60 the value of the set of semantic parameters, following the list determined at S50 (i.e., following the list of subsets, firstly modifying parameters in the first subset, then in the second, and so on). Thereby the method obtains an updated value of the set of semantic parameters. The iterative modifying comprises at each iteration a reduction of an error between the one or more target 3D positions and a current 3D position of the semantic point. The iterative modifying is restricted at each iteration to the semantic parameters of the current subset of the list. In other words, at each iteration, the free variables of the iterative modifying are limited to the semantic parameters of the current subset of the list. All the semantic parameters of the current subset of the list may be such free variables.

The automatic process further comprises updating S70 the 3D representation of the 3D modeled object based on the updated value of the set of semantic parameters.

The method constitutes an improved solution for updating values of semantic parameters upon graphical interaction.

The 3D modeled object displayed at S10 has (e.g., is represented by) a feature tree (also called a "specification tree", "spec tree", or "feature graph"). Within the feature tree, some of the parameters associated to the nodes may be exposed to be easily edited. Such parameters are herein called "semantic parameters". Editing (e.g., updating, modifying, varying, changing the value of) a semantic parameter may modify the shape of the 3D modeled object. For example, a semantic parameter may be associated with a length or a thickness of a part of the 3D modeled object.

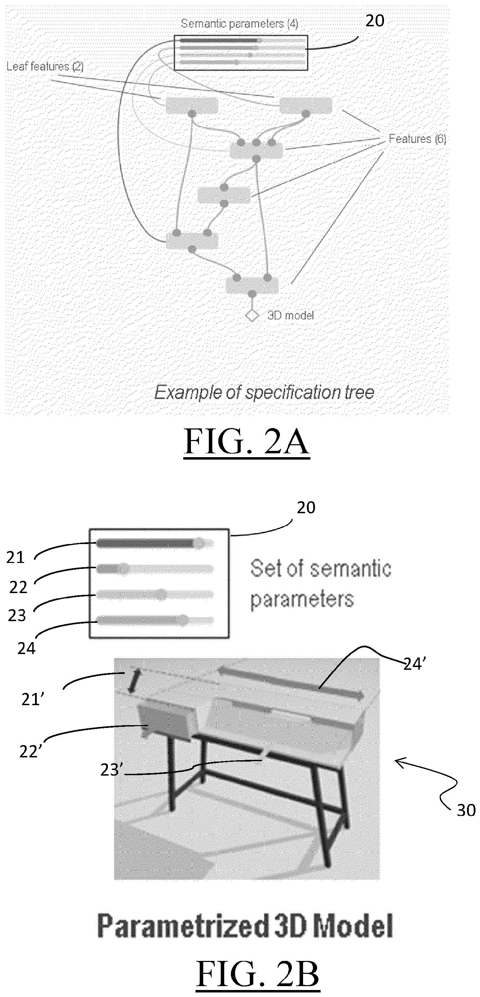

FIG. 2A illustrates an example of a feature tree with four semantic parameters 20. FIG. 2B illustrates the 3D modeled object associated with the feature tree of FIG. 2A, that is, desk 30. The semantic parameters 20 are related to different parameters of the desk: the parameter 21 is related to the overall width 21' of the desk, the parameter 22 is related to the position 22' of the drawer (position with respect the desk, e.g., whether it is inside or outside the desk), the parameter 23 is related to the width 23' of the writing (or work) surface, and the parameter 24 is related to the overall length 24' of the desk.

In the context of 3D model edition/design/modeling, manually editing the value of semantic parameter(s) may be time-consuming and not user-friendly. Indeed, the effect of updating a specific semantic parameter on the entire design may be unclear. It may be complicated to understand which semantic parameters to modify to obtain the desired result. Therefore, the user may have to manually select and manually modify the value of several parameters, iteratively, until being satisfied with the result. The manual edition of the semantic parameters may be very tricky (i.e., not intuitive and time-consuming), especially for 3D model objects with many semantic parameters. Moreover, the semantic parameters of 3D modeled objects may be the result of solvers (e.g., the results of simulations or optimization programs) and may be complicated to interpret. The solvers may be related to manufacturing or use constraints of the 3D modeled object. The semantic parameters may also have to respect bounds related to the use cases and/or manufacturing constraints of the mechanical product according to the 3D modeled object (e.g., a robot arm).

In some cases, the various parts of the design are related in complicated ways (e.g., complex mechanical designs, such as robot arms) and the number of possible combinations of parameters may be huge. It may be practically impossible (taking too much time, e.g., several hours) for a user to test all possible combinations of parameters and manually change the semantic parameters.

The method allows the user to modify a 3D modeled object through the graphical interactions S20 and 530. The method greatly enhances the ergonomics of designing a 3D modeled object, by allowing a user to automatically modify the semantic parameters to match their intentions. For example, the method may take as input two clicks with the mouse (a starting point S20 and an end point S30) and automatically update the 3D modeled object (by modifying the semantic parameters) to obtain that the point associated with the first click (herein called the "semantic point") is at the location of the second click. This is to be compared to the manual method, wherein the user has to navigate the feature tree (involving several interactions each requiring some time), manually modify the values of each of the involved semantic parameters, wait for the system to update the 3D modeled object, verify whether the updated 3D modeled object satisfies the wanted criteria, and, if it is not the case, start again. As a plurality of semantic parameters may be involved, this manual process may take considerable time. Therefore, the method reduces the time spent by the user and the number of interactions necessary, enhancing the ergonomics of designing a 3D modeled object.

FIG.s 3-4 show a solution different from the method to update desk 30 defined by semantic parameters 20.

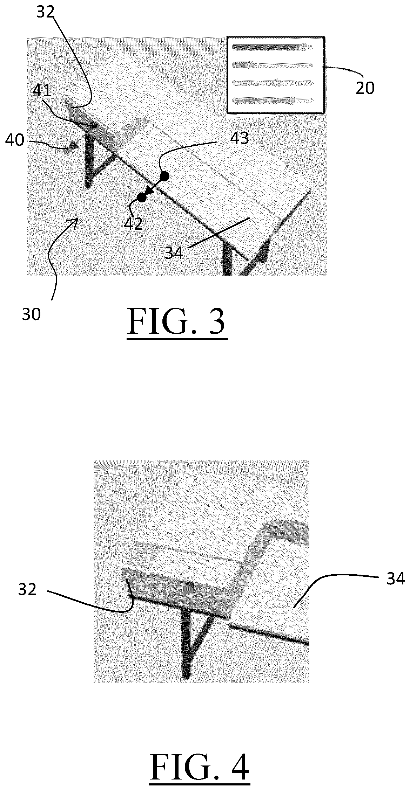

As shown on FIG. 3, the user selects a starting point 41 on the drawer 32 of the desk and a target location 40. The desk could be modified in several ways to obtain models fulfilling the constraint that the selected starting point 41 (corresponding to a semantic point) arrives at the target location 40.

FIG. 4 illustrates one solution (different from the one that would be obtained with the method) wherein the drawer 32 has been pulled out and only the writing surface 34 of the desk has been enlarged. This solution is clearly not acceptable from a mechanical point of view, as the drawer 32 cannot be closed anymore, thereby losing its mechanical functionality.

Different to this illustrated unacceptable solution, the method allows updating 3D modeled objects in a manner not only that follows the user intent with respect to the moving of the starting point defined by the user to the target point, thereby fulfilling the graphical constraint set by a user with the graphical selections S20 and 530, but also that is localized (and thus under fine control by the user, allowing flexibility) and results in a physical feasible object, and in particular in an object that can be manufactured (stays manufacturable). In other words, the method proposes a way to update the model in a meaningful way both for the user, in view of their graphical selections, and with respect to manufacturing and mechanical considerations and functions.

In particular, in the example corresponding to FIG. 3, the method would (not shown on the figures) result in the drawer 32 being drawn out of the desk 30. In other words, only the position of the drawer 32 would be modified, corresponding to the semantic parameters of the feature tree closest to the user-selection. In case the user rather desires to enlarge the desk (that is, increase the depth of the writing surface 34 and of the drawer 32 at once), the user may select and move a point on the writing surface 34, such as move point 43 to position 42. The method thus offers fine control and flexibility to the user, as depending on the graphical selection 520, the user may selectively only move the drawer 32, or increase width of the desk 32 (i.e. enlarge the writing surface 34).

The method would indeed execute as follows. In a first step, the user interacts with the 3D modeled object (desk 30) by selecting a starting point 41 and a target point 40. In a second step, the implementations may involve differentiating functions at the starting point 41 and iteratively modifying the value of the semantic parameters 20. In a third step, the 3D modeled object is updated and displayed to the user.

In particular, the method may update only the most relevant semantic parameters (e.g., only the semantic parameter that were intended to be modified by the user). In specific, the method introduces (at S50) a list of subsets of the set of semantic parameters that may be interpreted as a priority score to rank the semantic parameters. The method may iteratively update (at S60) the semantic parameters starting from those with higher priority. That is, the method may iteratively expand the set of semantic parameters used in the optimization process, thereby finding a solution wherein the higher priority semantic parameters are more likely to be updated, and the lower priority semantic parameters are less likely to be updated. The semantic parameters with higher priority may be those influencing (in priority) the operators affecting portions of the 3D modeled object near the starting point (e.g., a first click with a mouse).

The list of subsets determined at S50 interprets the intent of the user. By graphically selecting (at S20) the starting point somewhere on the design, the user may intend to modify the value of the semantic parameters influencing the features near said starting point. Therefore, the method is easier to use (e.g., more intuitive) than prior art methods. For example, as already discussed above, in the case of the desk of FIG. 3, whenever the starting point is on the drawer, the semantic parameter nearest to the starting point is the semantic parameter regarding the position of the drawer; the method prioritizes therefore pulling out the drawer (e.g., modify only the value of the semantic parameter related to the position of the drawer) instead of, as shown in FIG. 4, opening the drawer and enlarging the writing surface of the desk. In particular, the user may, by graphically selecting different points, modify the design in several different ways. FIG.s 7-9 discussed further below in the present disclosure, illustrate in three examples how the priority score (representing the list of subsets determined at S50) was used in implementations in the process optimizations of the semantic parameters.

The list of subsets determined at S50 may also reflect the physicality of the mechanical product represented by the 3D modeled object. That is, the list of subsets determined at S50 may allow to update the design in a physically plausible way, as if a force were applied at the starting point towards the end point.

Specifically, the method takes as input a 3D modeled object and one or more user graphical inputs (at S20 and S30), updates (automatically, according to steps S40, S50, and S60) the 3D modeled object according to the graphical inputs, and updates (at S70) the 3D representation of the updated 3D modeled object. That is, the method is for designing a 3D modeled object (e.g., an object defined by equations, parameters, and/or control points). The 3D modeled object represents a mechanical product. In particular, the mechanical product may be an assembly of mechanical parts. Each leaf node may represent at least a portion of an outer surface of one and only one respective mechanical part. The iteratively modifying S60 the value of semantic parameters may directly or indirectly modify the specifications of the mechanical parts.

The method may be included in a manufacturing process and/or the output of the method may directly be usable for manufacturing the product. For example, the method may include, after updating the 3D modeled object, storing the specifications of the updated 3D modeled object in a file and, optionally, converting them into manufacturing instructions (for example with a known CAD to CAM conversion process) for manufacturing a mechanical product modeled by said updated 3D modeled object. The determination/conversion of the CAM file may comprise (e.g., automatically) checking if the CAD model has any geometric particularity (e.g., error or artefact) that may affect the production process and (e.g., automatically) correcting such particularities. The method may also automatically send the manufacturing instructions and/or the stored file to a manufacturing machinery, so that the manufacturing machinery, following the instructions, produces the mechanical product represented by the updated 3D modeled object. The method may comprise the physical manufacturing or simply storing manufacturing instructions obtained from the specifications and output of the method and/or sending these instructions to the manufacturing process. The manufacturing of the mechanical product modeled by said updated 3D modeled object may comprise various processes, each interacting differently with the CAD model.

For example, the manufacturing process may comprise additive manufacturing (3D printing). In additive manufacturing, the production process does not comprise the step of determining the CAM file and directly proceeds to the producing/manufacturing step, by directly (e.g., and automatically) feeding a 3D printer with the CAD model. 3D printers are configured for, upon being fed with a CAD model representing a mechanical product (e.g., and upon launching, by a 3D printer operator, the 3D printing), directly and automatically 3D print the mechanical product in accordance with the CAD model.

Additionally or alternatively, the mechanical product may comprise, as non-limiting examples:

- a machined part (i.e., a part manufactured by machining), such as a milled part (i.e., a part manufactured by milling);
- a molded part (i.e., a part manufactured by molding), such as an injection-molded part; and/or
- a stamped part, also possibly referred to as "stamping part", i.e., a part to be manufactured in a stamping process.

In such cases, the manufacturing process may comprise (e.g., automatically) determining a CAM file based on the CAD model. The determining may comprise (e.g., automatically) performing a sequence of checks based on the CAD model to check that the geometry and/or distribution of material captured by the CAD model is adapted for the given manufacturing process. The CAM file may comprise specific instructions regarding the manufacturing process.

The method is for designing a 3D modeled object having a feature tree and an original value of a set of semantic parameters, each semantic parameter being associated to a respective node of the feature tree. The 3D modeled object displayed at S10 has a feature tree containing a number of nodes and connections, each node representing an operator. The feature tree is a directed acyclic graph (DAG; a graph wherein each connection has a direction and wherein there are no loops following the directions) representing the geometric parts and operations used to construct the 3D model. Each node (also called "feature") of the feature tree is associated with an operator (also called "operation" or "feature") that may involve creating, modifying, or combining one or more geometric objects. Each node is also associated with a geometric object, the result of said operator. The feature tree has a root node, and the geometric object associated with the root node is the entire 3D modeled object. The feature tree includes a plurality of parameters each of which is associated to at least one node. Some of the significant parameters (i.e., the semantic parameters) are exposed and are modifiable by the user. The set of semantic parameters may comprise one or more semantic parameters, each specifying quantitatively a geometrical property of the 3D modeled object. For example, the set of semantic parameters may comprise one or more semantic parameters each specifying a numerical parameter of a geometric operator represented by a node of the feature tree. For example, the set of semantic parameters may comprise one or more semantic parameters each specifying a dimension of one or more respective parts of the 3D modeled object and/or one or more semantic parameters each specifying a position of one or more respective parts of the 3D modeled object. Each semantic parameter specifying the dimension of the one or more respective parts may specify, as non-limiting examples, a height, a width, a length, a radius, a diameter, and/or any other numerical parameter specifying a size of at least one of the one or more respective parts. Each semantic parameter specifying the position of the one or more respective parts may specify, as non-limiting examples, an angle, a distance, and/or any other numerical relation between some of the parts of the one or more respective parts. The semantic parameters may correspond to (or influence, by any means) the coefficients of the equations describing portions of the 3D modeled object. For example, a node of the feature tree may represent an abstract cube, and the semantic parameters may represent the length of each edge of the cube, therefore allowing the formation of the equations necessary to describe a cube with the edges of the given length.

The 3D modeled object displayed at S10 may be obtained by any method known in the art. The method may be, for example, included in any other method for designing a 3D modeled object representing a mechanical part. Additionally or alternatively, obtaining the 3D modeled object may comprise retrieving from (e.g., local or distant) memory or receiving (e.g., from a remote system) a 3D modeled object (or the associated feature tree) having been thereby designed and/or stored.

The method comprises displaying S10 a 3D representation of the 3D modeled object. A 3D representation of the 3D modeled object displayed at S10 comprises a 3D space equipped with coordinates wherein the 3D modeled object is represented in the said coordinates. The displaying S10 may comprise rendering the 3D modeled object. Rendering a 3D modeled object may enable displaying the 3D representation of the 3D modeled object, e.g., on a screen. The displaying S10 may also include a visual presentation (i.e., a displaying) of the 3D representation. A visual presentation may be in two dimensions (e.g., on a screen) or in three (e.g., in a VR-environment). A visual presentation may comprise a visual presentation of the 3D representation of the 3D modeled object (e.g., in two dimensions). The visual presentation may also be described with coordinates (e.g., two coordinates for a 2D visual presentation, three coordinates for a VR-environment). The visual presentation of the 3D representation of the 3D modeled object may also be described in said coordinates. With the CAD system, the 2D visual presentation may be handled by the user and turned around any of its axes, or around any axis in the screen on which the representation is displayed, at will.

For example, the 3D representation displayed at S10 may be a viewpoint-representation. A viewpoint-representation may be a 3D representation that may enable viewing (e.g., displaying in a visual presentation) the 3D modeled object from different viewpoints in the 3D space. Many CAD systems comprise viewpoint-representations. The displaying S10 may include a viewpoint-representation and, optionally, a visual presentation of a viewpoint-representation. The visual presentation may include obtaining a viewpoint and may comprise visually presenting the 3D modeled object as it may be seen from the viewpoint. After obtaining a viewpoint, the visual presentation may comprise determining a 2D grid of pixels, each pixel corresponding to a line from the viewpoint and each pixel comprising the information whether the associated line intersect the representation of the 3D modeled object.

The method may include determining for each point in the 3D representation, an associated point in the visual presentation. For example, whenever the 3D representation is a viewpoint-representation, the method may comprise determining for each point in the viewpoint-representation a line from the viewpoint and passing through the point. Said line may correspond to a pixel (i.e., a point) in a 2D grid of a viewpoint-representation. The method may also include a method to compute for each point in the visual presentation, the associated one or more points in the 3D representation. For example, whenever the 3D representation is a viewpoint-representation, each point in the visual presentation may correspond to a line (and therefore to the points comprising the line) in the 3D representation.

The method comprises user graphical interactions with the 3D representation, including the graphical selection S20 and/or the graphical selection S30. By interaction, it is meant that the user may use an input device (e.g., a mouse, a keyboard, a touchscreen, a touchpad, a graphical tablet, and/or a VR-controller) to interact (e.g., select parts, click, touch, and/or drag-and-drop) with the 3D representation. The user graphical interactions may also include indirect interactions as detecting the user intent by hand tracking (e.g., in a VR environment) or any method of gaze-based interaction.

The graphical interaction may be on a visual presentation of the 3D presentation. By this, it is meant that the input device may be used to interact with the visual presentation (e.g., the screen, VR-environment). For example, the user may, e.g., select one or more points (or drag-and-drop) of the visual presentation. The method may comprise any method to infer, form an input in a visual presentation an input in the 3D representation.

The graphical selection S20 comprise graphically selecting a semantic point. A semantic point is an intrinsic point of the 3D modeled object, not depending on any 3D representation, visual presentation, and/or value of parameters. A semantic point is a point associated to the feature tree of the 3D modeled object, determined by a leaf node and coordinates. A semantic point may also include the information of a path from said leaf node to the root of the feature tree. The coordinates may be relative to the geometric object corresponding to the leaf node. A semantic point may have three coordinates, said coordinates being independent of the semantic parameters. A semantic point corresponds to a point of any 3D representation of the 3D modeled object. That is, the 3D modeled object is the result of the different operators comprised in the feature tree, each part of the 3D modeled object corresponding to at least one geometric object associated with a leaf node of the feature tree. For example, the association may be given by equations. A semantic point, through said association (e.g., said equations), determines a point of the 3D representation of the 3D modeled object. The determined point of the 3D representation may depend on the semantic parameters. The method may comprise any method to determine, from a semantic point, the associated point of the 3D representation (displayed at S10) and, thus, a point of any visual presentation of the 3D representation.

Conversely, the method may comprise determining, from each point of a 3D representation of the 3D modeled object and/or from each point of a visual presentation of a 3D representation of the 3D modeled object, one or more semantic points of the 3D modeled object. Such determining of one or more semantic points may comprise determining at least one geometric object associated with a leaf node of the feature tree. Said geometric object corresponding to a part of the 3D modeled object (in the 3D representation) comprising the point.

The graphical selection S20 may comprise selecting a point of the 3D representation corresponding to a semantic point. Selecting a point of the 3D representation comprises obtaining an input (e.g., from a user). The selected point of the 3D representation is an original 3D position (also called "starting point") of the semantic point. For example, selecting a point of the 3D representation may comprise selecting a point of the visual presentation of the 3D representation (e.g., by a user, e.g. with a click with the mouse, or any of the above methods of graphical interactions) and thereby inferring a point of the 3D representation by any of the above-described methods. Therefore, graphically selecting S20 may comprise determining a semantic point from a point of a visual presentation of the 3D representation (displayed at S10) of the 3D modeled object.

The graphically selecting S20 may also comprise determining from the obtained point of a 3D representation a point (e.g., a nearest point) associated with a semantic point of an outer surface of the 3D modeled object. The user may, for example, select a point of the interior of the model (in the VR-environment) or a point near the 3D modeled object (e.g., the input may be imprecise) and the method may automatically determine a point (e.g., a nearest point) of a 3D representation associated with a semantic point of an outer surface of the 3D modeled object.

The method further comprises graphically selecting S30 one or more target positions of the semantic point S30. A target position is a point in a 3D representation space of the 3D modeled object. Selecting one or more target positions may comprise any of the above methods of graphical interactions. For example, graphically selecting S30 may comprise selecting a point of a visual presentation and inferring one or more points (i.e., the one or more target positions) in the 3D representation.

For example, the displaying S10 of the 3D representation of the 3D modeled object may be performed on a screen of the CAD system based on a viewpoint. That is, the 3D representation may be a viewpoint-representation, and the visual presentation may be the associated visual presentation from a viewpoint. The graphically selecting S20 may comprise selecting a first 2D position of the screen such that a line from the viewpoint and intersecting the first 2D position also intersects the 3D representation. For example, the first 2D position may be a point (e.g., a pixel) associated with a line from the viewpoint which intersects the 3D modeled object in the 3D representation. Such a line may have a first intersection with the (represented) 3D modeled object, such intersection being used to determine the semantic point. That is, the semantic point graphically selected at S20 may be the semantic point associated with the point of the 3D representation obtained as the intersection of a line from the viewpoint, said line determined by the user graphical interaction on the visual presentation of the 3D representation. The graphically selecting S30 of the one or more target 3D positions may comprise selecting a second 2D position of the screen, the one or more target 3D positions consisting of all 3D positions of the line from the viewpoint and intersecting the second 2D position. That is, the one or more target positions may be all the points comprised in (i.e., consisting of) the line from the viewpoint in the 3D representation associated with the second 2D position.

After obtaining the 3D modeled object and the user graphical interactions S20 and 530, the method updates S70 (automatically) the representation of the 3D modeled object based on the updated values of a set of semantic parameters. That is, the method executes a series of steps (S40, S50, and S60) automatically by the CAD system, to update the values of a set of semantic parameters. After updating the semantic parameters, the method comprises updating the 3D modeled object according to the updated semantic parameters. The updating S70 comprises therefore updating the 3D representation on the base of the updated 3D modeled object (on the base of the updated semantic parameters).

Notably, the graphical selection S20 of a semantic point and the graphical selection S30 of one or more target positions of the sematic point may comprise two different user interactions, a first interaction for the graphical selection S20 of the semantic point and a second interaction for the graphical selection S30 of the one or more target positions. The first interaction may be performed before the second interaction. The method may comprise any way of informing the user that, after the first interaction has been performed, the first interaction has been registered (e.g., with a floating window, e.g., near the starting point) and that the system is waiting for the second interaction to happen. The two user interactions may comprise one or more clicks with a mouse, one or more touches on a touchpad, an interaction with a touchscreen (e.g., directly touching with a finger the wanted location on the screen), an interaction on a graphical tablet (e.g., with a pen used to interact with the graphical tablet), and/or in a VR environment (e.g., using a special controller, or directly using the hands). Therefore, in implementations, the graphical selection S20 of a semantic point and the graphical selection S30 of one or more target positions of the sematic point may comprise a click with a mouse at the starting position (e.g., as seen in a visual presentation) and a click with the mouse at a location corresponding to the one or more target positions. Implementations may allow similar interactions with the other above-mentioned input devices.

Additionally or alternatively, the graphical selection S20 of a semantic point and the graphical selection S30 of one or more target positions of the sematic point may be performed both at once via a drag-and-drop manipulation. That is, the method may enable the user to start the graphical selection at a point on the 3D representation space (or on a visual presentation) corresponding to a semantic point of the surface, then selecting a path from said point until a target destination and to stop the graphical selection at said target destination. The method may comprise any way of informing the user that, after the start of the graphical selection has been performed, the interaction has been registered (e.g., with a floating window, e.g., near the starting point, or near the current position of the cursor) and that the system is waiting for the stop of the graphical selection. The drag-and-drop manipulation may be performed with different input devices, as non-limiting examples:

- with a mouse, the start of the graphical selection may comprise pressing a button without releasing and the graphical selection may be stopped on the release of said button;
- with a touchpad, the start of the graphical selection may comprise touching the touchpad without releasing the finger and the graphical selection may be stopped when the finger is removed from the touchpad;
- with a touchscreen, the start of the graphical selection may comprise touching the screen without releasing the finger and the graphical selection may be stopped when the finger is removed from the screen;
- with a graphical tablet the start of the graphical selection may comprise touching the graphical tablet with a pen without releasing the pen and the graphical selection may be stopped when the pen is removed from the graphical tablet; and/or
- in a VR environment, with a special controller, or with a hand tracking method.

The method may include updating the 3D representation (and the associated visual presentation) in real time (e.g., after a few seconds, or after a fraction of a second, for example less than 4 seconds) upon the graphical selection S20 of the semantic point and/or the graphical selection S30 of the one or more target 3D positions. For example, the method may include automatically updating the 3D representation (and the associated visual presentation) directly after the second interaction or after the stop of the graphical selection while drag-and-dropping. The method may, alternatively, comprise requesting validation from the user before updating the 3D representation (and the associated visual presentation), e.g., with a floating window informing the user of the operation.

Additionally or alternatively, the method may comprise updating in real time the 3D representation (and the associated visual presentation) after graphically selecting S20 of a semantic point. That is, the method may comprise obtaining a first graphical input (e.g., a first interaction such a click, or a start of the graphical selection while drag-and-dropping), and updating in real time (e.g., every few seconds, or every fraction of a second) the representation of the 3D modeled considering as target position the location of the mouse/finger/pen/controller. The updated representation may be shown differently (e.g., in lighter colors, partially transparent), so that the user may visually see at the same time the original representation of the 3D modeled and the new representation of the 3D modeled object.

Allowing the user to see in real time the updated representation greatly enhances ergonomics. Indeed, the user may not know exactly the wanted modification of the 3D modeled object and the best target position of the selected semantic point, therefore being able to directly see the effect of the operation may further reduce the interactions necessary for designing a 3D modeled object.

The method includes determining S40 a leaf node of the feature tree representing a portion of the outer surface to which the semantic point belongs. As the semantic point is a point of at least one geometric object associated with a leaf node of the feature tree, the method automatically obtains from the semantic point a leaf node (e.g., one of the at least one geometric object, chosen with any method) of the feature tree.

The method further includes determining S50 a list of subsets of the set of semantic parameters. The list of subsets is increasing (e.g., strictly, or non-strictly), that is each subset of the list contains (e.g., strictly, or consists of) the elements of the preceding subsets of the list. For example, determining S50 may include a list of subsets indexed by a non-negative integer (e.g., a priority value, or a level value), greater indexes corresponding to bigger subsets. The list starts S51 with a subset containing each semantic parameter associated to the determined leaf node. That is, the first subset of the list contains (e.g., consists of) the semantic parameters associated to the determined leaf node. Each further subset of the list consists of the union between the previous subset in the list and any semantic parameter associated to a respective node of the feature tree which has a graph distance from the determined leaf node higher than the respective node of each semantic parameter of the previous subset. That is, each further subset of the list is obtained by adding S52 to the previous subset any semantic parameter associated to a respective node of the feature tree, the node having a graph distance from the determined leaf node higher than the respective node of each semantic parameter of the previous subset. For example, the second subset may consist of the first subset and any semantic parameters associated to the parent nodes of the determined leaf nodes (as a leaf node has no children nodes). For example, the second subset may consist of all the semantic parameters associated to the determined leaf node and its parent nodes. The third subset may consist of the second subset union the semantic parameters of the parent and children nodes of the parent nodes of the leaf. That is, at each iteration, all the semantic parameters of all the parent nodes and children nodes of the nodes considered in the previous subset are added. The iteration continues till the last subset is the entire set of semantic parameters.

By graph distance, it is meant a distance between the nodes of the feature tree seen as an undirected graph, the distance being dependent on a path between the nodes. For example, the distance between two nodes may be the minimal number of edges composing an undirected path between the two nodes, or other similarly defined distances.

The determining S50 may include determining the list of subsets using a notion of "priority level" of the semantic parameters. The priority level may be an integer. Specifically, each node of the feature tree may have a priority level, and each semantic parameter may have a priority level corresponding to the priority level of the associated node. Each subset of the list may consist of the set of semantic parameters of a given priority level. The leaf node determined at S40 may have the highest priority level. The priority level of the other nodes of the feature tree may depend on the distance from the determined leaf node, the higher the distance, the lower the priority.

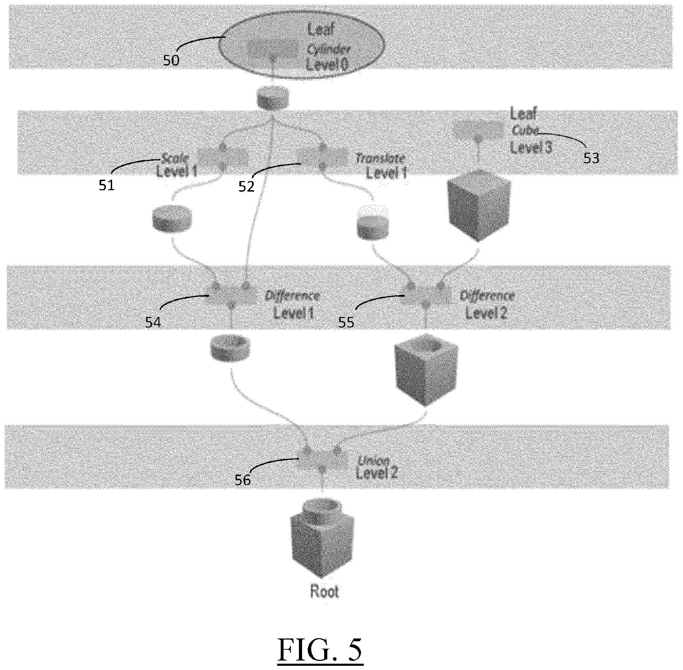

FIG. 5 illustrates a feature tree wherein each node has a value of a (priority) level, the level corresponding to the subsets defined at 550. The feature tree of FIG. 5 has a selected leaf 50. The level of each node is the graph distance between the node and the selected leaf 50. The list of subsets is given by the levels, that is the list of subsets comprises four subsets, each corresponding to the semantic parameters of the nodes with a level lower than a value, the value being between 0 and 3. Specifically, the only node of Level 0 is the leaf 50. For example, the first subset consists of all the semantic parameters associated to the leaf 50 (e.g., a radius, a height). Level 1 consists of all the nodes at distance 1 from the leaf, that is the parent nodes 51, 52, and 54. Therefore, the second subset of the list contains all the semantic parameters associated to the nodes 50, 51, 52, and 54. Level 2 consists of the nodes 55 and 56, and Level 3 consists of the node 53.

The method further includes iteratively modifying S60 the value of the set of semantic parameters, following the list (determined at S50), thereby obtaining an updated value of the set of semantic parameters. That is, the iteratively modifying S60 iterates over the list of subsets determined at 550, at each iteration updating the value of the semantic parameters of the current subset of the list. The iterative modifying S60 comprises at each iteration a reduction of an error between the one or more target positions (obtained at S30) and a current 3D position of the semantic point. The iterative modifying of S60 is restricted at each iteration to the semantic parameters of the current subset of the list. That is, the iteration step of the iteratively modifying S60 comprises reducing S61 an error between the one or more target 3D positions and a current 3D position of the semantic point by modifying the value of the semantic parameters of the current subset of the list. As the subset of the list is increasing some semantic parameters may be updated several times. This is a feature that improves the result, in particular when parameters depend on each other, such as with complex kinematics objects.

The iterative modifying S60 comprises executing one or more times the reducing S61, depending on the list of subsets obtained at 550. The reducing of the error at S61 is a consequence of the modifying the value of the semantic parameters. That is, after modifying the value of the semantic parameters, the current 3D position of the semantic point is updated accordingly, thereby reducing the error. The modifying the value of the semantic parameters may be the result of an optimization method. The optimization method may be designed to find the optimal value of the semantic parameters of the current subset of the list to minimize the error.

Specifically, the semantic point obtained at S20 has an original 3D position in the 3D representation space. For each value of the semantic parameters the semantic point is represented at a different point of the space. The error may, for example, be a distance between the one or more target 3D positions and the current 3D position. The error may be the 3D vector obtained as a difference between one of the one or more target 3D positions and current 3D position. For example, the 3D representation may be a viewpoint-representation. The one or more target 3D positions may be visually presented in just one point of the 2D visual presentation. The error may be computed directly from the 2D visual presentation. It may be a distance between the target position (in the 2D space) and the 2D visual presentation of the current 3D position. Alternatively, the error may be the 2D vector obtained as a difference between the 2D target position and the 2D visual presentation of the current 3D position.

The iterative process S60 may comprise a stopping criterion. For example, the iterative process S60 may include a step to check whether the subset of the list (determined at S50) is the last subset of the list. For example, the iterative process S60 may stop if the updated error in one of the iterations S61 is null. Alternatively, the iterative process S60 may stop if the updated error in one of the iterations S61 is smaller than a threshold, said threshold being obtained by the method in any way known in the art.

The iterative modifying S60 may further comprise initializing to zero (i.e., the 0-vector) a cumulated variation vector $x_{cum} \in R^n$ that represents a cumulated variation of the semantic parameters of the set of semantic parameters. Specifically, a cumulated variation vector may be a vector with n components with real coefficients, the number n being the number of semantic parameters of the 3D modeled object. The 3D modeled object may have original semantic parameters stored in a vector $h \in R^n$. Updating the semantic parameters may comprise determining a variation vector $s \in R^n$ (e.g., the cumulated variation vector $x_{cum}$) and adding the variation vector to the original semantic parameters $h$. After adding the variation vector, the 3D modeled object may be updated according to the new semantic parameters, and in particular, the 3D position of the semantic point may be updated accordingly.

The reduction of the error at each iteration S61 may comprise computing an optimal variation vector that represents an optimal variation of the semantic parameters of the current subset of the list. That is, each given iteration S61 may comprise computing a variation vector $x_f \in R^n$. The variation vector may have as non-zero entries only those corresponding to the semantic parameters included in the subset of the list of the given iteration. Each iteration may further comprise updating the cumulated solution using the variation vector, $x_{cum} = x_{cum} + x_f$. That is, the iterative modifying may comprise at each iteration updating the cumulated variation vector $x_{cum} = x_{cum} + x_f$ by adding the value of each coordinate of the optimal variation vector to the corresponding coordinate of the cumulated variation vector. The iterative modifying S60 may comprise updating the value of semantic parameters by adding the cumulated variation vector to the original value of semantic parameters $h + x_{cum}$.

The iterative modifying S60 may comprise determining one or more variation matrices $J'$. A variation matrix may represent a variation of a 3D position of the semantic point relative to a variation of the semantic parameters. That is, the variation matrix may represent (e.g., approximate, or compute) starting from the variation of the value of the semantic parameters, the variation of the 3D positions of the semantic point. The variation of the 3D positions of the semantic point may be the variation between the 3D position of the semantic point before the variation and after the variation of the semantic parameters. Specifically, the values of the semantic parameters may be stored in a vector $h'$ and the variation in a vector $x$. The vector $J'x$ obtained as the product of the variation matrix $J'$ and the variation vector $x$ may represent (e.g., approximate, or compute) the variation of 3D positions of the semantic point. For example, the current 3D position may be represented (e.g., approximated, or computed) by the original 3D position plus the term $J'x$. For example, the variation of semantic parameters may be the cumulated variation vector $x = x_{cum}$, and the variation of 3D positions of the semantic point may be represented (e.g., be or approximated) by $J'x_{cum}$.

The variation matrix may be a Jacobian matrix, e.g., of a position-function. A Jacobian may define a linear approximation of a position-function, providing an effective variation matrix. The position-function may be a function determining the 3D current position (i.e., the three coordinates determining the position in the 3D representation) of the semantic point depending on the set of semantic parameters. The variation matrix $J'$ may also represent a variation of the original 3D position of the semantic point relative to a variation of the semantic parameters. For example, the variation matrix $J'$ may be the Jacobian of the position-function computed at the original 3D position, that is, at the starting semantic parameters $h$. Computing only once a variation function (e.g., a Jacobian, the Jacobian of the position function) at the original 3D position increases the efficiency of the method, decreasing the computation time needed for updating the 3D modeled object. The variation matrix $J'$ may be relative to the current subset of the list. That is, each iteration S61 may comprise computing a variation matrix $J'$ relative to the subset. The variation matrix relative to the current subset of the list may be a variation matrix only representing a variation of a 3D position of the semantic point relative to a variation of the semantic parameters of the current subset of the list. For example, a variation matrix relative to a current subset may be obtained from a given variation matrix (e.g., a Jacobian, the Jacobian of the position function). The given variation matrix may, optionally, be computed at the original 3D position. The variation matrix relative to a current subset may be the given variation matrix wherein each of the columns associated with a semantic parameter not in the list is set to be the 0-vector.

Alternatively, the variation matrix $J'$ may represent a variation of a 2D position in a 2D visual presentation of the 3D representation (e.g., the viewpoint-representation) of the semantic point. That is, the variation matrix $J'$ may be any of the previously discussed variation matrices (e.g., a Jacobian, a Jacobian of the original 2D-position) with the exception of representing (e.g., approximating, or computing) a variation of 2D-positions of the visually presented semantic point. For example, a variation matrix $J'$ may be a Jacobian matrix of the position-function composed with the visual presentation function (e.g., a projection from a viewpoint-representation along the point of view).

The optimal variation may minimize a distance between a product of a variation matrix with a candidate variation vector and a corresponding value of the error e. That is, the optimal variation $x_f$ may be such that the product $J'x_f$ of the variation matrix $J'$ is as close as possible (e.g., with respect to a distance) to an error e. The distance may be derived from a norm, or a norm squared. The norm may be an $L^2$-norm. For example, the optimal variation may minimize the norm squared $\|J'x - e\|^2$ or the norm $\|J'x - e\|$.

The error in the reduction at each iteration S61 may be equal to a distance between a value of a measurement of the one or more target 3D positions and a value of a measurement of the original 3D position as modified by the cumulated variation vector. A measurement of the one or more target 3D positions may be denoted $p_{end}$ and a measurement of the original 3D position may be denoted $p_{start}$. A measurement of the one or more target 3D positions may be one of the one or more target positions. Alternatively, the measurement may be a position in a 2D visual presentation of the 3D representation, or in another visual presentation and/or representation. Analogously, a value of a measurement of the original 3D position may be the original 3D position, the position in a 2D visual presentation of the 3D representation, or in another visual presentation and/or representation. In particular, $p_{start}$ and $p_{end}$ may be 2- or 3-dimensional vectors. The cumulated variation $x_{cum}$ may represent the variation of the value of the semantic parameters. The reducing S61 may comprise a variation matrix $J$ (e.g., a Jacobian) that represent the variation of the original 3D position of the semantic point relative to a variation of the semantic parameters. Therefore, the product $Jx_{cum}$ may represent (e.g., approximate, or compute) the variation of 3D positions of the semantic point. The term $(p_{start} + Jx_{cum})$ may represent a current position of the semantic point. The error may be the vector $e = p_{end} - (p_{start} + Jx_{cum})$. The error may be a 2- or 3-dimensional vector.

At each iteration, the reducing S61 may include computing an optimal variation of minimal norm. Computing an optimal variation of minimal norm may comprise determining a vector $x$ of minimal norm among all vectors for which the norm $\|J'x - e\|$ is minimal. The variation vector of minimal norm $x_0$ may be obtained as a product $(J')^+e$ of a pseudo-inverse $(J')^+$ of the variation matrix with the value of the error e. The pseudo-inverse $(J')^+$ may the Moore-Penrose inverse. The Moore-Penrose inverse is well-known in the art. The Moore-Penrose inverse may be advantageous as the product $(J')^+e$ has, by construction, minimal norm. Therefore, at each iteration S61, the optimal variation $x_f$ may, therefore, be $(J')^+e$, wherein the variation matrix $J'$ may depend on the iteration, e.g., wherein $J'$ is a Jacobian matrix of the position-function (or position-function composed with the visual presentation function), optionally, with respect to the original position. Optionally, wherein $J'$ is further modified so that each column associated with a semantic parameter not in the list is set to be the 0-vector.

At each iteration S61, the optimal variation vector $x_f$ may minimize the distance under a constraint. The constraint may penalize any variation of the value of the semantic parameters of the previous subset in the list relative to the any semantic parameters of the current subset of the list. The constraint may depend on a constraint matrix $C'$. A constraint matrix may be a $n \times n$ matrix that may depend on the current iteration S61, that is, on the subset of the list determined at 550. The constraint matrix may impose a priority on updating the semantic parameters, so that the optimizations of the previous step may not be lost at the given step.

The constraint may consist in an equality to 0 of the product of the constraint matrix $C'$ with the candidate variation vector $x$, i.e., $C'x = 0$. Alternatively, the constraint may be to minimize the norm $\|C'x\|$. The norm may be the $L^2$-norm. The constraint matrix may be a diagonal matrix. The constraint matrix may be a square matrix having a non-zero value (e.g., value 1) on its diagonal for each coordinate corresponding to a semantic parameter of the previous subset in the list, and a zero value elsewhere. The values on the diagonal may be all equal (that is, constant) or different from each other. Therefore, the constraint may involve minimizing the norm of the entries of the candidate variation vector corresponding to a semantic parameter of the previous subset in the list.

The optimal variation vector at each iteration S61 may, therefore, be a minimizer of the norm $\|J'x_f - e\|$ under the constraint of minimizing $\|C'x_f\|$. Therefore, the optimal variation vector may satisfy $x_f = x_0 + P'y_0$, wherein $x_0$ is a minimizer of $\|J'x_0 - e\|$ with minimal norm, and $P'$ is a kernel matrix of the variation matrix $J'$. Each iteration S61 may include determining a vector $y_0$ such that the norm $\|C'x_f\| = \|C'(x_0 + P'y_0)\|$ is minimal. That is, the optimal variation vector may be equal to the sum between a variation vector of minimal norm that minimizes said distance $x_0$ and a product of a kernel matrix of the Jacobian variation matrix $P'$ with an adjustment vector of minimal norm $y_0$ such that the constraint is met. The adjustment vector $y_0$ may be a vector of minimal norm equal to the opposite of the product of a first sub-product with a second sub-product $y_0 = -(C'P')^+C'x_0$, the first sub-product being a pseudo-inverse of the product of the constraint matrix with the kernel matrix $(C'P')^+$, the second sub-product being the product of the constraint matrix $C'$ with the variation vector of minimal norm $x_0$. That is, the adjustment vector $y_0$ may be of the form $y_0 = -(C'P')^+C'x_0$, wherein $(C'P')^+$ may be the pseudo-inverse of $C'P'$. In particular, the adjustment vector of minimal norm may be determined using a Moore-Penrose inverse method.

Specifically, each iteration S61 may include obtaining a variation vector $x_f$ as the sum of a variation vector of minimal norm $(J')^+e$ and an adjustment vector of minimal norm $-P'(C'P')^+C'(J')^+e$. That is, each iteration S61 may include obtaining a variation vector $x_f = (J')^+e - P'(C'P')^+C'(J')^+e$, wherein $(J')^+$ is a pseudo-inverse of a variation matrix (e.g., the Moore-Penrose inverse), $P'$ is a kernel matrix of $J'$ and $(C'P')^+$ is a pseudo-inverse of $C'P'$ (e.g., the Moore-Penrose inverse). Each iteration S61 may include updating the cumulative variation vector $x_{cum} = x_{cum} + x_f = x_{cum} + (J')^+e -$

$P'(C'P')^+C'(J')^+e.$

The 3D modeled object of the method may include, for each of the semantic parameters associated to each of the nodes, a definition domain. In particular, at least one semantic parameter of the 3D modeled object of the method may have a bounded definition domain. The definition domain may be bounded, e.g., a bounded interval. A definition domain may be a set of allowed values of the associated semantic parameter. The definition domain may, for example, directly come from manufacturing constraints. For example, a semantic parameter may determine a fillet radius, and such radius may depend, e.g., on the bending properties of the metal used to produce the mechanical products, or on the stamping machinery used in the manufacturing. The definition domain may represent the bending properties of the material, or the stamping possibilities of the machinery. The method may be implemented so as to stay within the definition domain, and, in particular, the method may be designed to always respect the manufacturing constraints imposed by the definition domains. That is, the method may automatically find allowable solutions without the need for further methods.

Specifically, the iterative modifying S60 may comprise at each iteration, after the updating, applying an out-of-boundary management process configured for clamping each value of a respective semantic parameter out of its definition domain to a nearest boundary. That is, each iteration S61 may comprise clamping each value of a respective semantic parameter out of its definition domain to a nearest boundary. For example, each iteration S61 may comprise computing a variation x of semantic parameters, said variation to be added to the values $h'$ of the semantic parameters, and S61 may further comprise clamping (i.e., modifying) the vector x so as the values $h' + x$ of the updated semantic parameters respect the bounds of definition. The clamping may comprise, e.g., determining a closest value for each coordinate of x so as, the values $h' + x$ of the updated semantic parameters respects the bounds of definition. The variation x may be the optimal variation $x_f$ or the cumulative variation vector $x_{cum}$.

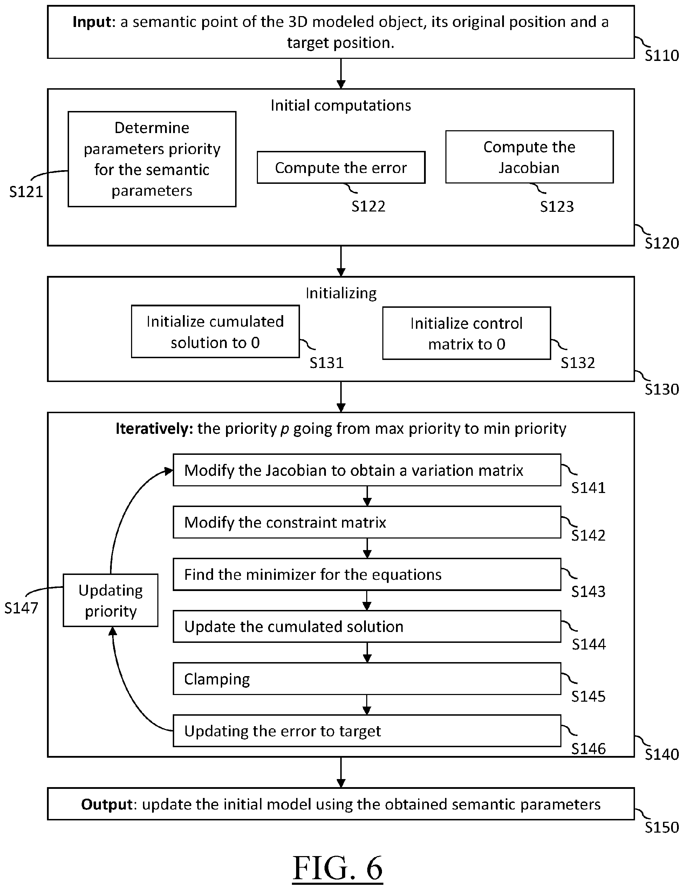

FIG. 6 shows an implementation of the different steps of the method. The implementation was further tested on three examples (corresponding to FIG.s 7-9) to show the efficacy of the method.

For each step, the corresponding step(s) of the flowchart of FIG. 1 is(are) indicated. In the implementation, the 3D representation is the viewpoint-representation, and the visual presentation is on a 2D graphical interface, e.g., a screen. Variants of the implementation may comprise different 3D representations and/or visual presentations. The implementation includes obtaining a 3D modeled object and the associated feature tree. The 3D modeled object depends on n semantic parameters included in the feature tree. The values of the semantic parameters are stored in a vector $h \in R^n$. The feature tree of the 3D modeled object may include parameter bounds.

The implementation requires obtaining S110 an input. S110 comprises obtaining a semantic point. The semantic point $p^S$ in the implementation is obtained through a graphical input on the 2D visual presentation of the viewpoint-representation. That is, the implementation includes obtaining a starting point (i.e., an original position) $p_{start} \in R^2$ in the 2D visual presentation of the 3D-modeled object corresponding to a semantic point. Herein, the space $R^2$ may correspond to the coordinates of the 2D graphical interface as seen by the user. The starting point may be obtained in any way, for example in the ways described at graphically selecting 520. The input 5110 further comprises obtaining a target position $p_{end} \in R^2$, a point in the graphical user interface expressing the target position. Obtaining a target position may be implemented in any way according to S30.

The implementation further comprises initial computations 5120 starting from the input. The initial computations 5120 include three independent steps S121, S122, and S123, but in variants the initial computations may be different. S121 (corresponding to S20, S40, and S50) consists in determining parameters priority for the semantic parameters. The determining 5121 includes selecting the leaf node of the feature tree associated with the $p^S$. Selecting the leaf node may be implemented in any way according to S40. Zero or more semantic parameters may be associated to the leaf node (corresponding to S51). These parameters are given priority 0. Priority 0 is interpreted as maximal priority, priority 1 is interpreted as a lower priority than 0 and higher than priority 2, so that the lowest priority is associated with the priority with highest integer value. Afterwards, the determining 5121 comprises selecting all the nodes of the feature tree at graph-distance 1 from the selected leaf node and giving priority 1 to all the semantic parameters associated to said nodes (i.e., all the parent nodes are selected, and the associated parameters are given priority 1). The determining 5121 further comprises, iteratively (corresponding to S52) giving to each semantic parameter a priority value equal to the graph-distance of the associated node to the leaf node in the feature tree. The process stops (corresponding to S53) after that all the semantic parameters have a priority value. In variants, the parameter priority may be computed in any other method.

S122 consists of computing the error. The error is the vector $e = p_{end} - p_{start} \in R^2$ indicating the direction of the displacement of the selected point. In variants, the error may be different.

S123 consists of computing a Jacobian matrix $J$ at $p_{start}$. The Jacobian matrix is a matrix of size $2 \times n$, defining a linear application $J: R^n \rightarrow R^2$. The Jacobian matrix may be computed as follows. The point $p_{start}$ is associated with the semantic point $p^S$ of semantic coordinates $(u, v, w)$ in a volume V associated to the leaf node. The semantic point $(u, v, w)$ has coordinates $V(u, v, w) \in R^3$ in the 3D representation of the associated modeled object. The representation depends on the value of the semantic parameters $(x_i)_{i=1,...,n}$. That is, $V(u, v, w)$ depends on the value of the semantic parameters $(x_i)_{i=1,...,n}$. Given new values of semantic parameters $(x'_i)_{i=1,...,n}$, new 3D coordinates $V'(u, v, w)$ of the point associated with the semantic point $p^S$ may be determined. The association from the semantic parameters to the 3D point can be derived to obtain a Jacobian:

$$J_P^{3D} = \left( \frac{V'(u,v,w) - V(u,v,w)}{\delta x_k} \right)_{k=1,\ldots,n}.$$

The map $V(u, v, w)$ is further composed with the map from $R^3 \to R^2$ used to display the viewpoint-representation in the 2D visual presentation (e.g., the projection along the viewpoint). The Jacobian of S123 is the Jacobian of the composed function:

$$J = J_P^{2D} = J_P^{Camera} \times J_P^{3D}.$$

In variants, the variation matrix computed at the original position may be different than the Jacobian, or the Jacobian may be computed differently.

The implementation further comprises initializing S130 a cumulated solution $x_{cum} \in R^n$ to be the 0-vector 5131 and a constraint matrix $C$ of size $n \times n$ to be the 0-matrix S132, but in variants the initializations may be different and/or absent.

The implementation further comprises an iterative process S140. The iterative process 5140 comprises several steps S141-S147 that are repeated a number of times depending on the depth of the feature tree. Specifically, the iterative process 5140 comprises iteratively updating the cumulated solution $x_{cum}$ and the error e at each priority $\boldsymbol{p}$, wherein the priority parameter $\boldsymbol{p}$ start at the highest priority (i.e., priority 0, corresponding to the parameters of the determined leaf node). The priority may be updated at S147, and it may be increased by 1 at each time. The iterative process 5140 ends when the priority reaches the lowest priority (i.e., maximal integer value, corresponding to the semantic parameters associated to the furthest nodes to the determined leaf node). In variants, a different number of steps and/or different implementations of each of the steps may be implemented. For example, variants may include other stopping criteria.

S141 consists of modifying the Jacobian $J$ computed at S123 to obtain a variation matrix $J'$. Specifically, $J' = J$, further imposing that $J'$[i] is the 0-vector for all parameters i having a priority higher than $p$ (i.e., the parameters $i$ corresponding to nodes at distance higher than $p$). In variants, the variation matrix $J'$ may be obtained in any other way.

S142 consists of modifying the constraint matrix of S142. Specifically, the modified constraint matrix $C'$ satisfies $C' = C$, further imposing that $C'[i][i] = 1$ for every parameter $i$ having a priority lowerthan $\boldsymbol{p}$ (i.e., the parameters i corresponding to nodes at distance lower than $\boldsymbol{p}$). In variants, the constraint matrix $C'$ may be obtained in any other way.

S143 consists of finding a vector as a minimizer of two norms, but in variants different optimization processes may be implemented. The variation matrix $J'$ is used for setting the following equation (hereinafter called Equation (1)):

$$J'x = e \qquad (1).$$

Any solution of Equation (1) may give possible parameters corrections to move the semantic point along the direction given by $e$. However, the Equation (1) may not have a (single) solution. Therefore, instead of finding solutions for Equation (1), the implementation comprises finding minimizers of (hereinafter called Norm (2))

$$\|J'x - e\|^2 \qquad (2).$$

Norm (2) may be minimized using the Moore-Penrose inverse method. The pseudo inverse $(J')^+$ of $J$ is determined using the singular value decomposition (svd). The pseudo inverse is used to determine an element $x_0 = (J')^+e$ that is the solution that minimizes Norm (2) of minimal $\|.\|$ norm. If Equation (1) does not admit any solution, then $x_0$ is the vector that approaches the solution the best (because it minimizes Norm (2)).

A kernel matrix $P'$ of size $n \times n$ of $J'$ may be determined with the svd decomposition. The matrix $P'$ satisfies that $\forall y \in R^n, J'P'y = 0$. Thus, the solutions of the Equation (1) are $x = x_0 + P'y$ for any y. Similarly, if $x_0$ minimizes Norm (2), $x = x_0 + P'y$ also minimizes Norm (2).

To select one of the possible solutions to Equation (1) and/or minimizer of Norm (2), the constraint matrix $C'$ is considered. The possible solutions considered may be solutions of the equation (hereinafter called Equation (3))

$$C'x = 0 \qquad (3).$$

As $x$ is a solution of Equation (1) and/or a minimizer of Norm (2), the following decomposition follows from the above $x = x_0 + P'y$. If it is a solution of Equation (3), it must also be a solution of:

$$C'P'y = -C'x_0.$$

To solve this equation, the Moore-Penrose inverse method may be used. That is, the elements considered are the elements $y$ minimizing (hereinafter called Norm (4)):

$$\| C'P'y + C'x_0 \|^2 \qquad (4).$$

Using the pseudo inverse $(C'P')^+$ of $C'P'$, it is obtained that the element $y_0 = -(C'P')^+ C'x_0$ is a minimizer of Norm (4). If Equation (3) admits multiple solutions, then $y_0$ is the one with minimal norm. If Equation (3) does not admit any solution, then $y_0$ is the vector that approaches the solution the best (because it minimizes Norm (4)).

S143 consists in taking:

$$x_f = x_0 + P'y_0 = x_0 - P'(C'P')^+ C'x_0 = (J')^+ e - P'(C'P')^+ C'(J')^+ e$$

as the selected minimizer of Norms (2) and (4).

S144 consists of updating the cumulated solution:

$$x_{cum} := x_{cum} + x_f.$$

S145 is optional. S145 may be present only if the feature tree of the 3D modeled object includes parameter bounds. S145 consists of clamping the updated cumulated solution:

$$x_{cum} := clamping(x_{cum})$$

in such a way that the parameters

$$clamping(x_{cum}) + h$$

are valid parameters values for the 3D model (i.e., they are within the bounds, if such bounds are present). Specifically, all values of $x_{cum}$ are updated to the closest valid value such that all the values of *clamped*$(x_{cum}) + h$ are valid. In variants, the clamping step may be absent or implemented differently.

S146 consists of updating the error:

$$e := p_{end} - (p_{start} + Jx_{cum}).$$

After S146, the iterative process 5140 further comprises checking whether the priority value $p$ is maximal. If it is not the case, the iterative process 5140 further comprises S147, consisting in updating the priority $p = p + 1$. Afterwards, the implementation starts again from S141 with updated priority. Otherwise, S140 ends.

The implementation may further comprise an output step S150, the 3D model is updated using the semantic parameters $h_f = h + x_{cum}$.

In the implementation, during the iterative step S140, if at any point the obtained cumulated solution $x_{cum}$ is a solution for both Equations (1) and (3), then it is the optimal solution. Indeed, as $Jx_{cum} = e$, the error gets updated to 0:

$$e := p_{end} - (p_{start} + Jx_{cum}) = 0$$

and at each further iteration in Step S140, $x_f = 0$, as both $x_0$ and $y_0$ have minimal norm.

In the implementation, the updated cumulative solution $x_{cum}$ obtained at S144 may correspond to semantic parameters outside the corresponding bounds, as S143 and 5144 may not respect the bounds. The step of clamping, S145, may introduce errors (it may not be a solution of Equation (1) anymore and/or may not minimize Norm (2)), but the iterative process handles this by minimizing Norm (4) with new current error to target.

A pseudo-code of the implementation may be:

```
get user inputs p_start and p_end given a 3D model with current semantic parameters h
get parameters priority for selected part from spec tree (0 is highest priority)
compute error to target e = p_end − p_start
compute Jacobian matrix J at p_start

set cumulated solutions x_cum = [0, ..., 0]  # delta parameters
set squared matrix C to zero

for p in (0, ..., max_priority):
    set J':=J then J'[i]:=0-vector for parameters i having a priority p' > p (lower-priority parameters)
    set C':=C then C'[i][i]:=1 for parameters i having a priority p' < p (higher-priority parameters)
    find a minimizer using J', e, and C' to obtain x_f
    set x_cum := x_cum + x_f
    out of boundary management of x_cum (clamping)

    compute new estimated error to target: e = p_end − (p_start + Jx_cum)

update the 3D model using the semantic parameters h_f = h + x_cum
```

Three explicit examples are presented to illustrate the above implementation on explicit 3D modeled objects. The examples are illustrated in FIG.s 7-9. For each of the explicit 3D modeled object, the above implementation is compared to an unconstrained method.

In the following, the implementation of the method shown on FIG. 6 is compared to an unconstrained method which serves as a reference or control.

The unconstrained method takes as input the same input of Step S110 of the implementation. The unconstrained method further comprises computing an error $e := p_{end} - p_{start}$ as in Step 122 and computing a Jacobian $J$, as in Step 123 of the implementation. The unconstrained method further comprises finding a minimizer $x$ of (hereinafter called Norm (2'))

$$\|Jx - e\|^2 \quad (2').$$

The unconstrained method further comprises choosing a possible minimizer of Norm (2'), e.g., a minimizer of minimal norm. Such minimizer $x_f$ is the parameter variation that is used to update the parameters of the modeled object, that is $h := h + x_f$.

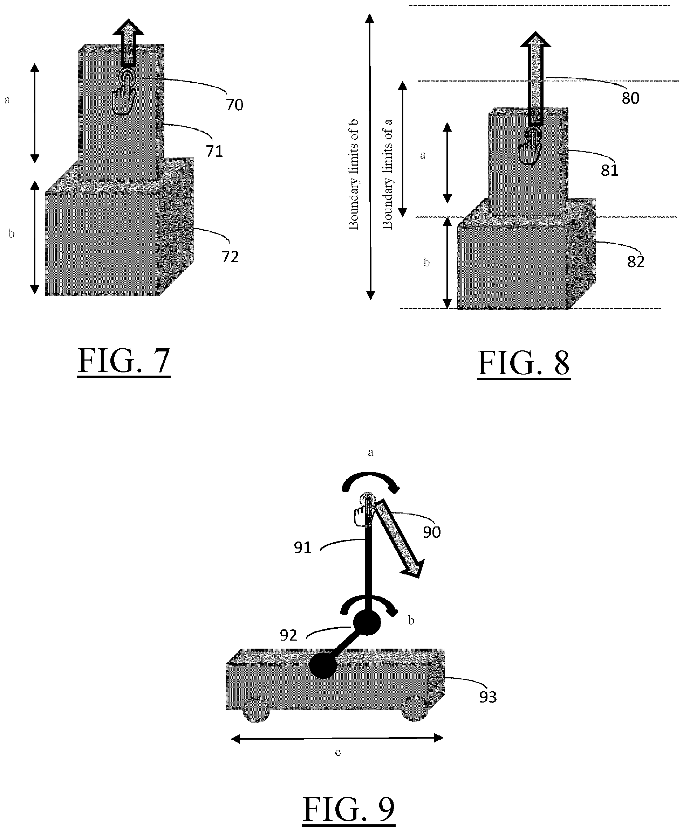

FIG. 7 illustrates a first explicit example of the above implementation on a 3D modeled object. FIG. 7 illustrates two boxes that are stacked, with box 71 over box 72. The user select a point $p_{start}$ indicated at position 70 and chooses a target position $p_{end}$ that is vertical over the point (i.e., the coordinates $p_{start}$ and $p_{end}$ differ only on one coordinate, the second coordinate). The selected point $p_{start}$ is associated with a semantic point. Each of the boxes depends only on one parameter determining the respective height and the initial parameters associated with the modeled object are $h = (a, b)$.

As the target point is vertical over the point 70, the vector $e := p_{end} - p_{start}$ is a vertical vector, that is it is of the form e = (0,y), wherein y is the (Euclidean) distance between $p_{start}$ and $p_{end}$.

The Jacobian may be expressed as follows:

$$J = \begin{pmatrix} 0 & 0 \\ 1 & 1 \end{pmatrix}.$$

The output according to the unconstrained method may be derived as follows. The unconstrained method comprises finding a minimizer for Norm (2'), that is, a vector $x$ satisfying $x_a + x_b = y$. For example, the unconstrained method may select a vector of minimal norm. For example, the unconstrained method may select the vector satisfying $x_a = x_b = y/2$. Therefore, both boxes may be modified, and their height may be increased. This solution may not correspond to the user intent. Since the user only selected a point on the box 71, the user may have intended to modify the parameters only of the box 71 and not both parameters.

The output according to the above implementation may be derived as follows. In the implementation, the leaf node associated with the semantic point is the node associated with box 71. The node associated with box 72 is of lower priority. That is, in the vector $x = (x_a, x_b)$ the coordinate $x_a$ has priority 0 and $x_b$ has priority 1 (S121). The implementation further comprises the initialization S130:

$$C = \begin{pmatrix} 0 & 0 \\ 0 & 0 \end{pmatrix} \text{ and } x_{cum} = (0,0).$$

In iterative process S140 the priority is set to 0, and the implementation further comprises modifying the Jacobian S141 to obtain the variation matrix:

$$J' = \begin{pmatrix} 0 & 0 \\ 1 & 0 \end{pmatrix}.$$

The implementation further comprises modifying S142 the constraint matrix. As the priority is 0, C = C'. The implementation further comprises finding minimizers for Norms (2) and (4). As C' is the null matrix, any vector is solution of Equation (3) and minimizes Norm (4). The vector x = (y, 0) is the solution of Equation (1) of minimal norm, indeed:

$$J'x = (0, y) = e.$$

Therefore, the cumulated solution is updated $x_{cum}$ = (y, 0). As none of the semantic parameters has a bounded definition domain 5145 may be skipped. The implementation further comprises of updating S146 the error to 0. As x is a solution of both Equations (1) and (3), the implementation may be designed to stop at this step. Otherwise, the implementation further comprises updating S147 the priority to 1. In this iteration, the variation matrix is equal to the Jacobian, J = J', and the constraint matrix is updated:

$$C' = \begin{pmatrix} 1 & 0 \\ 0 & 0 \end{pmatrix}.$$

As the updated error e = 0, the trivial vector $x_f$ = (0,0) is solution to Equations (1) and (3) and therefore $x_{cum}$ = (y, 0) is not modified.

The output of the implementation 5150 is the modeled object with parameters h' = h + $x_{cum}$ = (a + y, b). The implementation, therefore, only modifies the parameter of box 71 and not of the box 72. This is more realistic, as the user only selected a point from 71 and may expect that only box 71 is modified.

FIG. 8 illustrates a second explicit example of the above implementation on a 3D modeled object. The modeled object illustrated in FIG. 8 is the same as the one of FIG. 7: it consists of two boxes with box 81 stacked over box 82. The user selects a point indicated at position 80 and chooses a target position vertical over the point. Each of the boxes depends only on one parameter determining the respective height. The initial parameters associated with the modeled object are h = (a, b). In the modeled object illustrated in FIG. 8 the semantic parameters have bounded domain. That is, there are values $a_{max}$ and $b_{max}$ such that all possible semantic parameters h' = (a',b') associated with the model object must satisfy that $a' < a_{max}$ and $b' \leq b_{max}$.

As the target point is vertical over the point 80, the vector e := $p_{end}$ - $p_{start}$ is a vertical vector, that is it is of the form e = (0,y), wherein y is the (Euclidean) distance between $p_{start}$ and $p_{end}$.

The Jacobian has the same expression as in FIG. 7, namely:

$$J = \begin{pmatrix} 0 & 0 \\ 1 & 1 \end{pmatrix}.$$

The output according to the unconstrained method may be derived as follows. As in the example illustrated in FIG. 7, a minimizer for Norm (2) is any vector x = ($x_a$, $x_b$) satisfying $x_a$ + $x_b$ = y. The unconstrained method may select any vector satisfying the equation, and the selected solution may not respect the bounds $x_a$ + a $\leq a_{max}$ and $x_b$ + b $\leq b_{max}$. For example, we may have that $x_a$ = $x_b$ = y/2.

The output according to the implementation may be derived as follows. In the implementation, the leaf node associated with the semantic point is the node associated with box 81. The node associated with box 82 is of lower priority. That is, in the vector x = ($x_a$, $x_b$) the coordinate $x_a$ has priority 0 and $x_b$ has priority 1 (S121). The implementation further comprises the initialization step S130:

$$C = \begin{pmatrix} 0 & 0 \\ 0 & 0 \end{pmatrix} \text{ and } x_{cum} = (0,0).$$

In the iterative process S140 the priority is set to 0, and the implementation further comprises modifying the Jacobian S141 to obtain the variation matrix:

$$J' = \begin{pmatrix} 0 & 0 \\ 1 & 0 \end{pmatrix}.$$

The implementation further comprises modifying the constraint matrix S142, and as the priority is 0, $C = C'$. The implementation further comprises finding minimizers for Norms (2) and (4). As $C'$ is the null matrix, any vector is solution of Equation (3) and minimizes Norm (4). The vector x = $(y, 0)$ is the solution of Equation (1) of minimal norm, indeed:

$$J'x = (0, y) = e.$$

Therefore, the cumulated solution is updated $x_{cum} = (y,0)$. The implementation further comprises clamping S145 the solution. If $a + y < a_{max}$, then, the implementation proceeds as in the case illustrated in FIG. 7 and the vector $x_{cum} = (y, 0)$ is used to update the modeled object. Otherwise, the implementation at S145 updates the vector:

$$x_{cum} = clamping(x_{cum}) = (\hat{y}, 0)$$

wherein $y = a_{max} - a < y$. The implementation further comprises updating S146 the error:

$$e := p_{end} - (p_{start} + Jx_{cum}) = (0, y - \hat{y}).$$

The implementation further comprises updating S147 the priority to 1. In this iteration, the variation matrix is equal to the Jacobian, $J = J'$, and the constraint matrix is updated:

$$C' = \begin{pmatrix} 1 & 0 \\ 0 & 0 \end{pmatrix}.$$

The implementation further comprises finding S143 a minimizer for the equations. The vector $x_0 = ((y - y)/2, (y - y)/2)$ is a solution of Equation (1) with minimal norm. However, $C'x_0 = ((y - y)/2,0)$ is not 0, so $x_0$ is not a solution of Equation (3). Therefore, the implementation further determines the adjustment vector $P'y_0 = (-(y - y)/2, (y - y)/2)$. Then

$$x_f = x_0 + P'y_0 = (0, y - \hat{y})$$

is a solution to Equation (1), as $Jx_f = (0, y - \hat{y}) = e$ and to Equation (3), as $C'x_f = (0,0)$. The implementation further comprises updating the cumulated solution:

$$x_{cum} = x_{cum} + x_f = (\hat{y}, y - \hat{y}).$$

The implementation further comprises clamping S145 the solution, that is the implementation updates $x_{cum} = (\hat{y}, \hat{z})$ for a determined value $\hat{z} \leq y - \hat{y}$.

The implementation updates S150 the initial model with parameters $h' = (a + y, b + \hat{z})$. Therefore, the implementation firstly increases as much as possible the height of the box 81, and if the parameter bounds are reached, further proceeds to increase the height of the box 82. If also the bounds for the second box are reached, the updated model may not fully comply with the requirement of the user, as they may be impossible within the bounds.

FIG. 9 illustrates a third explicit example of the above implementation on a 3D modeled object. The model illustrated has three degrees of freedom. An angle $a$ of the bar 91 (e.g., with respect to the horizontal axes), an angle $b$ of the bar 92 (e.g., with respect to the horizontal axes), and a horizontal position (e.g., the horizontal position of the center of mass of the model with respect to the origin) of a box 93. Therefore, the initial parameters associated with the modeled object are $h = (a, b, c)$.

A point 90 is selected by the user and a target position for said point is selected according to the arrow. The output according to the unconstrained method may have that all the values of the semantic parameters are modified. E.g., the unconstrained method may modify the horizontal position parameter $c$, whereas it may not be necessary to modify the parameter. The user may, for example, only intend to move the attached bar (e.g., in the case the target position is closed to the original position) and not the entire design.

The output according to the implementation may be derived as follows. In the implementation, the leaf node associated with the semantic point is the node associated with bar 91. The node associated with bar 92 is of lower-priority and the node associated with box 93 is the lowest-priority. That is, in the vector $x = (x_a, x_b, x_c)$ the coordinate $x_a$ has priority 0, $x_b$ has priority 1, and $x_c$ has priority 2 (S121). The error and the associated Jacobian matrix $J$ are computed (S122 and S123). The implementation further comprises the initialization step, S130:

$$C = \begin{pmatrix} 0 & 0 & 0 \\ 0 & 0 & 0 \\ 0 & 0 & 0 \end{pmatrix} \text{ and } x_{cum} = (0,0,0).$$

The implementation further comprises modifying S141 the Jacobian to obtain a variation matrix and comprises modifying S142 the constraint matrix. As the priority is 0, C = C'. The implementation further comprises finding minimizers for Norms (2) and (4). As C' is the null matrix, any vector is solution of Equation (3) and minimizes Norm (4). Therefore, the implementation comprises finding a minimizer of Norm (2) of minimal norm. As the variation matrix is 0 on the coordinates with non-zero priority, the minimizer is of the form $x_{cum} := x_f = (x_a, 0, 0)$ (S144). However, $x_{cum}$ may not satisfy Equation (1), as no solution may exist only optimizing the first parameter. The implementation further comprises updating the error to the target accordingly S146. As $x_{cum}$ may not be a solution to Equation (1), the method may continue, the priority being updated to 1 at Step S147. The implementation further comprises the second iteration of S140. For this a second variation matrix is obtained 5141 and the constraint matrix is modified S142 as follows:

$$C' = \begin{pmatrix} 1 & 0 & 0 \\ 0 & 0 & 0 \\ 0 & 0 & 0 \end{pmatrix}.$$

The implementation further comprises finding S143 the minimizer of the updated equations, the minimizer being of the form $x_f = (x'_a, x_b, 0)$. The solution $x_f$ may, for example, be a solution of Equation (1), but may not be a solution for Equation (3) as the first parameter is re-optimized. The implementation further comprises updating the solution $x_{cum} = (x_a + x'_a, x_b, 0)$. If $x_{cum}$ is a solution of Equation (1), the error is updated to the 0-vector.

The implementation may comprise a last iteration. In the last iteration, the variation matrix is the Jacobian (S141) and the constraint matrix is modified (S142):

$$C' = \begin{pmatrix} 1 & 0 & 0 \\ 0 & 1 & 0 \\ 0 & 0 & 0 \end{pmatrix}.$$

The implementation further comprises finding S143 the minimizer of the updated equations, the minimizer may be for example the 0-vector, that is $x_f = (0,0,0)$. The implementation further comprises updating the solution $x_{cum}$.

The implementation updates the initial model 5150 with parameters h' = h + $x_{cum}$. The updated parameter may, for example, be $h' = (a + x_a + x'_a, b + x_b, c)$. Therefore, the implementation:

- minimizes the error by rotating the bar 91;
- if no solution is found, minimizes the error by rotating both bar 91 and 92, while trying not to rotate the bar 91 (due to minimizing Norm (4) and the shape of the constraint matrix);
- if no solution is found, minimizes the error by rotating bar 91, rotating bar 92, and translating the box 93, while trying not to rotate either bar (due to minimizing Norm (4) and the shape of the constraint matrix).

The implementation may therefore respect the intent of the user by updating the parameters most affecting the point (e.g., the geometric objects closer to the point, bars 91 and 92).

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

The method generally manipulates modeled objects. A modeled object is any object defined by data stored e.g. in the database. By extension, the expression "modeled object" designates the data itself. According to the type of the system, the modeled objects may be defined by different kinds of data. The system may indeed be any combination of a CAD system, and/or a CAM system. In those different systems, modeled objects are defined by corresponding data. One may accordingly speak of CAD object, CAM object, CAD data, CAM data. However, these systems are not exclusive one of the other, as a modeled object may be defined by data corresponding to any combination of these systems. A system may thus well be both a CAD and CAM system, as will be apparent from the definitions of such systems provided below.

By CAD system, it is additionally meant any system adapted at least for designing a modeled object on the basis of a graphical representation of the modeled object, such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 3D modeled object, e.g. representing a product such as a part or an assembly of parts, or possibly an assembly of products. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object may represent the geometry of a product to be manufactured in the real world subsequent to the completion of its virtual design with for instance a CAD software solution or CAD system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolve, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By CAM solution, it is additionally meant any solution, software of hardware, adapted for managing the manufacturing data of a product. The manufacturing data generally includes data related to the product to manufacture, the manufacturing process and the required resources. A CAM solution is used to plan and optimize the whole manufacturing process of a product. For instance, it can provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. Such CAM solutions are provided by Dassault Systèmes under the trademark DELMIA®.

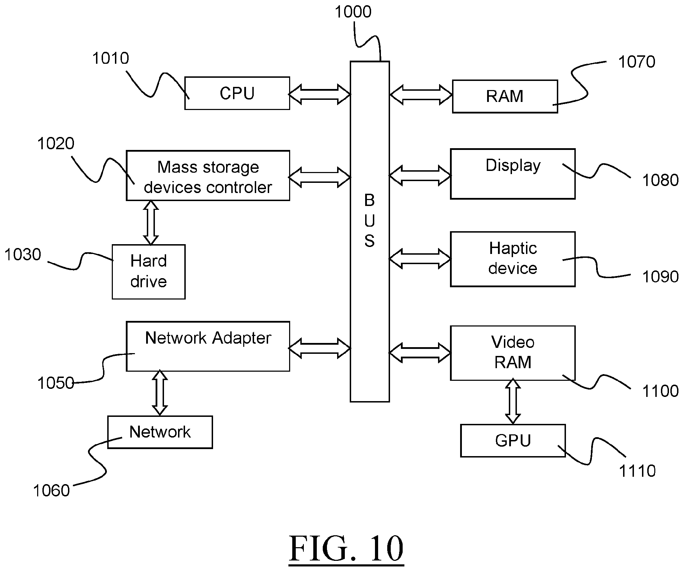

FIG. 10 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

"Designing a 3D modeled object" designates any action or series of actions which is at least part of a process of elaborating a 3D modeled object. Thus, the method may comprise creating the 3D modeled object from scratch. Alternatively, the method may comprise providing a 3D modeled object previously created, and then modifying the 3D modeled object.

The method may be included in a manufacturing process, which may comprise, after performing the method, producing a physical product corresponding to the modeled object. In any case, the modeled object designed by the method may represent a manufacturing object. The modeled object may thus be a modeled solid (i.e. a modeled object that represents a solid). The manufacturing object may be a product, such as a part, or an assembly of parts. Because the method improves the design of the modeled object, the method also improves the manufacturing of a product and thus increases productivity of the manufacturing process.

**Claims**

1. A computer-implemented method of designing a 3D modeled object representing a mechanical product, the 3D modeled object having a feature tree and an original value of a set of semantic parameters, each semantic parameter being associated to a respective node of the feature tree, the method comprising:

- by a CAD system, displaying (S10) a 3D representation of the 3D modeled object;
- by a user graphically interacting with the 3D representation:

    ■ graphically selecting (S20) a semantic point of an outer surface of the 3D modeled object, the semantic point having an original 3D position; and
    ■ graphically selecting (S30) one or more target 3D positions of the semantic point; and

- automatically by the CAD system:

    ■ determining (S40) a leaf node of the feature tree representing a portion of the outer surface to which the semantic point belongs;
    ■ determining (S50) a list of subsets of the set of semantic parameters, the list starting (S51) with a subset consisting of any semantic parameter associated to the determined leaf node, each further subset in the list consisting of the union between the previous subset in the list and any semantic parameter associated to any respective node of the feature tree among one or more respective nodes of the feature tree which each have a graph distance from the determined leaf node higher than the respective node of each semantic parameter of the previous subset, the list ending (S53) with the set of semantic parameters;
    ■ iteratively modifying (S60) the value of the set of semantic parameters, following the list, thereby obtaining an updated value of the set of semantic parameters, the iterative modifying comprising at each iteration a reduction of an error ($e = p_{end} - (p_{start} + Jx_{cum})$) between the one or more target 3D positions and a current 3D position of the semantic point, the iterative modifying being restricted at each iteration to the semantic parameters of the current subset of the list; and
    ■ updating (S70) the 3D representation of the 3D modeled object based on the updated value of the set of semantic parameters.

2. The method of claim 1, wherein the iterative modifying (S60) comprises initializing to zero a cumulated variation vector ($x_{cum}$) that represents a cumulated variation of the semantic parameters of the set of semantic parameters, and the reduction of the error at each iteration comprises computing an optimal variation vector ($x_f$) that represents an optimal variation of the semantic parameters of the current subset of the list that minimizes a distance ($\|J'x - e\|^2$) between a product ($J'x$) of a variation matrix ($J'$) with a candidate variation vector $(x)$ and a corresponding value of the error ($e = p_{end} - (p_{start} + Ix_{cum})$), the variation matrix ($J'$) representing a variation of a 3D position of the semantic point relative to a variation of the semantic parameters of the current subset of the list, the iterative modifying comprising at each iteration updating the cumulated variation vector ($x_{cum} := x_{cum} + x_f$) by adding the value of each coordinate of the optimal variation vector to the corresponding coordinate of the cumulated variation vector.

3. The method of claim 2, wherein the variation matrix ($J'$) represents a variation of the original 3D position of the semantic point relative to a variation of the semantic parameters of the current subset of the list.

4. The method of claim 2 or 3, wherein the optimal variation vector ($x_f$) minimizes said distance under a constraint $(C'x = 0)$ that penalizes any variation of the value of the semantic parameters of the previous subset in the list relative to the any semantic parameter of the current subset of the list.

5. The method of claim 4, wherein the constraint ($C'x = 0$) consists in an equality to 0 of the product ($C'x$) of a constraint matrix ($C'$) with the candidate variation vector ($x$), the constraint matrix being a square matrix having a non-zero value on its diagonal for each coordinate corresponding to a semantic parameter of the previous subset in the list, and a zero value elsewhere, the non-zero value being optionally positive and/or constant, for example equal to 1.

6. The method of claim 5, wherein the optimal variation vector ($x_f$) is equal to the sum ($x_0 + P'y_0$) between a variation vector of minimal norm ($x_0$) that minimizes said distance and a product ($P'y_0$) of a kernel matrix ($P'$) of the variation matrix ($J'$) with an adjustment vector of minimal norm ($y_0$) such that the constraint is met.

7. The method of claim 6, wherein the variation vector of minimal norm ($x_0$) is equal to the product ($J'^+e$) of a pseudo-inverse ($J'^+$) of the variation matrix with the value of the error ($e = p_{end} - (p_{start} + Jx_{cum})$), the variation vector of minimal norm ($x_0$) being optionally determined using a Moore-Penrose inverse method, and/or the adjustment vector of minimal norm ($y_0$) is equal to the opposite of the product ($-(C'P')^+C'x_0$) of a first sub-product ($(C'P')^+$) with a second sub-product ($C'x_0$), the first sub-product ($(C'P')^+$) being a pseudo-inverse ($(C'P')^+$) of the product ($C'P'$) of the constraint matrix ($C'$) with the kernel matrix ($P'$), the second sub-product being the product of the constraint matrix ($C'$) with the variation vector of minimal norm ($x_0$), the adjustment vector of minimal norm ($y_0$) being optionally determined using a Moore-Penrose inverse method.

8. The method of any one of claims 2 to 7, wherein at least one semantic parameter has a bounded definition domain, the iterative modifying comprising at each iteration, after the updating, applying an out-of-boundary management process configured for clamping each value of a respective semantic parameter out of its definition domain to a nearest boundary.

9. The method of any one of claims 2 to 8, wherein the error in the reduction at each iteration is equal to a distance (($p_{end}$ - ($p_{start}$ + $Jx_{cum}$)) between a value ($p_{end}$) of a measurement of the one or more target 3D positions and a value ($p_{start}$ + $Jx_{cum}$) of a measurement of the original 3D position as modified by the cumulated variation vector.

10. The method of any one of claims 1 to 9, wherein the displaying (S10) of the 3D representation of the 3D modeled object is performed on a screen of the CAD system based on a viewpoint, the graphically selecting of the semantic point comprises selecting a first 2D position of the screen such that a line from the viewpoint and intersecting the first 2D position also intersects the 3D representation, and the graphically selecting of the one or more target 3D positions comprises selecting a second 2D position of the screen, the one or more target 3D positions consisting of all 3D positions of the line from the viewpoint and intersecting the second 2D position.

11. The method of any one of claims 1 to 10, wherein the graphically selecting (S20) of the semantic point and the graphically selecting (S30) of the one or more target 3D positions are performed both at once via a drag-and-drop manipulation, and/or the updating of the 3D representation is performed real time upon the graphically selecting of the semantic point and/or the graphically selecting of the one or more target 3D positions.

12. The method of any one of claims 1 to 11, wherein the mechanical product is an assembly of mechanical parts, each leaf node representing at least a portion of an outer surface of one and only one respective mechanical part.

13. A computer program comprising instructions which, when executed by a processor, cause the processor to perform the designing method according to any one of claim 1 to 12.

14. A data storage medium having stored thereon the computer program of claim 13.

15. A computer system comprising memory having stored thereon the computer program of claim 13, and a processor coupled to said memory and configured to execute the computer program.

system

| displaying a 3D representation of the 3D modeled object; | S10 |

user

| graphically selecting a semantic point of an outer surface of the modeled object | S20 |

user

| graphically selecting one or more target positions of the semantic point | S30 |

system

| determining a leaf node of the feature tree representing a portion of the outer surface to which the semantic point belongs; | S40 |

determining a list of subsets of the set of semantic parameters: — S50

the list starting with a subset containing each semantic parameter associated to the determined leaf node — S51

adding any semantic parameter associated to any among one or more respective nodes having a higher graph distance — S52

the list ending with the set of semantic parameters — S53

system

iteratively modifying the value of the set of semantic parameters — S60

reducing an error between the one or more target 3D positions and a current 3D position of the semantic point by modifying the value of the semantic parameters of the current subset of the list — S61

system

| updating the 3D representation of the 3D modeled object based on the updated value of the set of semantic parameters | S70 |

system

## FIG. 1

Example of specification tree

## FIG. 2A

Parametrized 3D Model

## FIG. 2B

FIG. 3

FIG. 4

FIG. 5

**Input:** a semantic point of the 3D modeled object, its original position and a target position.

S110

Initial computations

Determine parameters priority for the semantic parameters

S121

Compute the error

S122

Compute the Jacobian

S123

S120

Initializing

Initialize cumulated solution to 0

S131

Initialize control matrix to 0

S132

S130

**Iteratively:** the priority *p* going from max priority to min priority

Modify the Jacobian to obtain a variation matrix

S141

Modify the constraint matrix

S142

Find the minimizer for the equations

S143

Update the cumulated solution

S144

Clamping

S145

Updating the error to target

S146

Updating priority

S147

S140

**Output:** update the initial model using the obtained semantic parameters

S150

FIG. 6

FIG. 7

FIG. 8

FIG. 9

## FIG. 10

Europäisches
Patentamt

European
Patent Office

Office européen
des brevets

# EUROPEAN SEARCH REPORT

**Application Number**

EP 25 30 5002

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | QIN XIAOLIAN ET AL: "Automatic Update of Feature Model After Direct Modeling Operation", COMPUTER-AIDED DESIGN AND APPLICATIONS, vol. 18, no. 1, 22 May 2020 (2020-05-22), pages 170-185, XP093275612, US ISSN: 1686-4360, DOI: 10.14733/cadaps.2021.170-185 * abstract * * pg. 172, Algorithm 1 section 3.3.3; figures 1, 8 * | 1-15 | INV. G06F30/17 |
| A | US 2024/403502 A1 (SCHMIDT MARTIN-PIERRE [FR]) 5 December 2024 (2024-12-05) * abstract * * [0006], [0007], [0033], [0034], [0041], [0046], [0047], [0069], [0088], [0107], [0123], [0124], [0126]; claim 1; figure 6 * | 1-15 | |
| A | US 10 706 186 B2 (DASSAULT SYSTEMES [FR]) 7 July 2020 (2020-07-07) * abstract * * col. 4, 11, 13-16; claims 1, 4, 7; figures 4, 5, 10-12 * | 1-15 | |

TECHNICAL FIELDS
SEARCHED (IPC)

G06F

-----

-----

-----

-/--

The present search report has been drawn up for all claims

| Place of search | Date of completion of the search | Examiner |
|---|---|---|
| Munich | 6 June 2025 | Brandiska, Pavlina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...................................................................................

& : member of the same patent family, corresponding document

EPO FORM 1503 03.82 (P04C01)

**page 1 of 2**

| | Europäisches Patentamt<br>European Patent Office<br>Office européen des brevets | **EUROPEAN SEARCH REPORT** | **Application Number**<br>EP 25 30 5002 |

## DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
|---|---|---|---|
| A | KODNONGBUA MILIN ET AL: "ReparamCAD:<br>Zero-shot CAD Re-Parameterization for<br>Interactive Manipulation",<br>PROCEEDINGS OF THE 29TH ACM SYMPOSIUM ON<br>VIRTUAL REALITY SOFTWARE AND TECHNOLOGY,<br>ACMPUB27, NEW YORK, NY, USA,<br>10 December 2023 (2023-12-10), pages 1-12,<br>XP059620977,<br>DOI: 10.1145/3610548.3618219<br>ISBN: 979-8-4007-0330-0<br>* abstract *<br>* section 1, 3.5, 4;<br>figures 1, 2 *<br>----- | 1-15 | |
| | | | **TECHNICAL FIELDS<br>SEARCHED (IPC)** |

The present search report has been drawn up for all claims

| Place of search | Date of completion of the search | Examiner |
|---|---|---|
| Munich | 6 June 2025 | Brandiska, Pavlina |

## ANNEX TO THE EUROPEAN SEARCH REPORT
## ON EUROPEAN PATENT APPLICATION NO.

EP 25 30 5002

This annex lists the patent family members relating to the patent documents cited in  the above-mentioned European search report.
The members are as contained in the European Patent Office EDP file on
The European Patent Office is in no way liable for these particulars which are merely given for the purpose of information.

06-06-2025

| Patent document cited in search report | | | Publication date | Patent family member(s) | | | Publication date |
|---|---|---|---|---|---|---|---|
| US  2024403502 | A1 | | 05-12-2024 | CN | 119066790 | A | 03-12-2024 |
| | | | | EP | 4471649 | A1 | 04-12-2024 |
| | | | | JP | 2024178120 | A | 24-12-2024 |
| | | | | US | 2024403502 | A1 | 05-12-2024 |
| US  10706186 | B2 | | 07-07-2020 | CN | 107092741 | A | 25-08-2017 |
| | | | | EP | 3203394 | A1 | 09-08-2017 |
| | | | | JP | 6966842 | B2 | 17-11-2021 |
| | | | | JP | 2017174409 | A | 28-09-2017 |
| | | | | US | 2017220730 | A1 | 03-08-2017 |

EPO FORM P0459

For more details about this annex : see Official Journal of the European Patent Office, No. 12/82